(19) Europäisches Patentamt
European Patent Office
Office européen des brevets

(11) **EP 4 107 861 B1**

(12) **EUROPEAN PATENT SPECIFICATION**

(45) Date of publication and mention of the grant of the patent:
**27.05.2026 Bulletin 2026/22**

(21) Application number: **20706708.3**

(22) Date of filing: **21.02.2020**

(51) International Patent Classification (IPC):
***H03L 7/087*** *(2006.01)* ***H03L 7/089*** *(2006.01)*
***H03L 7/093*** *(2006.01)* ***H03L 7/107*** *(2006.01)*
***H03L 7/197*** *(2006.01)*

(52) Cooperative Patent Classification (CPC):
**H03L 7/0891; H03L 7/087; H03L 7/093; H03L 7/1072; H03L 7/1075; H03L 7/1972; H03L 7/1978**

(86) International application number:
**PCT/EP2020/054601**

(87) International publication number:
**WO 2021/164881 (26.08.2021 Gazette 2021/34)**

(54) **HYBRID ANALOG/DIGITAL PHASE LOCKED LOOP WITH FAST FREQUENCY CHANGES**

HYBRIDE ANALOGE/DIGITALE PHASENREGELSCHLEIFE MIT SCHNELLEN FREQUENZÄNDERUNGEN

BOUCLE À VERROUILLAGE DE PHASE ANALOGIQUE/NUMÉRIQUE HYBRIDE À CHANGEMENTS DE FRÉQUENCE RAPIDES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**28.12.2022 Bulletin 2022/52**

(73) Proprietor: **Telefonaktiebolaget LM ERICSSON (PUBL)**
**16483 Stockholm (SE)**

(72) Inventors:
- **SJÖLAND, Henrik**
  **224 68 Lund (SE)**
- **MARIN, Razvan-Cristian**
  **226 57 Lund (SE)**

(74) Representative: **Ericsson Patent Development**
**Torshamnsgatan 21-23**
**164 80 Stockholm (SE)**

(56) References cited:
**WO-A2-2007/106414 US-A- 6 028 460**
**US-A1- 2011 133 799**

- **FRIEDMAN DANIEL: "Hybrid PLL architectures and implementations", 2018 IEEE CUSTOM INTEGRATED CIRCUITS CONFERENCE (CICC), IEEE, 8 April 2018 (2018-04-08), pages 1 - 89, XP033339210, DOI: 10.1109/CICC.2018.8357110**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 107 861 B1

## Description

### TECHNICAL FIELD

The present invention relates generally to a Phase Locked Loop circuit, and in particular a hybrid PLL operating under an analog control loop in steady-state and a digital control loop during frequency changes.

### BACKGROUND

Wireless communication networks, including network nodes and radio network devices such as cellphones and smartphones, are ubiquitous in many parts of the world. These networks continue to grow in capacity and sophistication. To accommodate both more users and a wider range of types of devices that may benefit from wireless communications, the technical standards governing the operation of wireless communication networks continue to evolve. The fourth generation of network standards has been deployed (4G, also known as Long Term Evolution, or LTE), and the fifth generation is in development (5G, also known as New Radio, or NR).

5G is not yet fully defined, but in an advanced draft stage within the Third Generation Partnership Project (3GPP). 5G wireless access will be realized by the evolution of LTE for existing spectrum, in combination with new radio access technologies that primarily target new spectrum. Thus, it includes work on a 5G NR Access Technology, also known as next generation (NX). The NR air interface targets spectrum in the range from below 1 GHz up to 100 GHz, with initial deployments expected in frequency bands not utilized by LTE. A general description of the agreements on 5G NR Access Technology so far is contained in 3GPP TR 38.802 V0.3.0 (2016-10), of which a draft version has been published as R1-1610848. Final specifications may be published *inter alia* in the future 3GPP TS 38.2** series.

Not only is NR targeted to very high frequencies (GHz range), but it will feature advanced communication techniques, including spatial diversity and/or spatial multiplexing; beamforming; and frequency hopping.

Spatial diversity refers to transmitting the same signal on different propagations paths (e.g., different transmit/receive antennas), which increases robustness against fading, cochannel interference, and other deleterious effects of RF signal transmission. Spatial multiplexing also uses multiple transmit and receive antennas, and refers to transmitting different portions of data on different propagation paths, using space-time coding, to increase data rates. These techniques are collectively referred to as Multiple Input, Multiple Output, or "MIMO."

Beamforming refers to the use of antennas having increased and controllable directionality, whereby an RF transmission is narrow, and is "aimed" in a specific direction. This may be accomplished by the use of a phased-array antenna comprising a large plurality of antenna elements. The relative phases of transmit signals sent to each antenna element are controlled to create constructive or destructive interference, thus amplifying the signal at some antenna elements and attenuating it at others, and hence controlling the direction in which the beam is transmitted. Similar phase manipulation of signals from antenna elements in a receive antenna can also result in beamforming the sensitivity of a phased-array antenna in receiving signals.

As the term implies, frequency hopping refers to RF transmission by rapidly changing the carrier frequency, in a predetermined or calculable manner, among one or more sets of distinct frequencies within a frequency band. Frequency hopping minimizes the effect of interference at any given frequency, such as from conventional narrowband communications, as transmission and reception occur at that frequency for only a brief duration. Conversely, a frequency hopping transmitter imposes minimal interference on the conventional narrowband system, for the same reason. Frequency hopping minimizes the probability of interference among transmitters in the same network, as they are unlikely to hop on the same pattern at the same time. The technique also improves security, as the signal cannot be intercepted without knowledge of the frequency hopping pattern.

All of these advanced communications techniques require highly precise, agile, phase-accurate periodic signal generators, for example to generate the Local Oscillator (LO) signal used to down-convert a received signal from the carrier frequency to baseband (and *vice versa* for a transmitted signal). MIMO and beamforming require precise phase alignment between different generated high-frequency signals, and frequency hopping requires that the signal generators can rapidly hop from one frequency to the next, with minimal transition and settling time.

A well-known circuit used to generate a periodic signal from a known reference frequency, such as that provided by a crystal oscillator or other precise source, is a Phase Locked Loop (PLL). A PLL operates according to a negative feedback control loop, in which the phase of a generated signal is locked to that of a reference signal. A basic modern PLL comprises a reference source, a phase frequency detector (PFD), a charge pump (CP), a loop filter (LF), and a voltage controlled oscillator (VCO). To generate a higher frequency output than the reference signal, a divider circuit is included internally, dividing the output of the VCO. The phase of the divided VCO output is compared with the phase of the reference signal at the PFD (for simplicity, the VCO output is considered herein to be divided by one if no divider circuit is included). The polarity of the measured phase difference controls whether a Charge Up (CU) or Charge Down (CD) signal is input to the charge pump. The charge pump responsively generates and injects positive or negative current into an integrating capacitor in the loop filter, transferring charge to or from the capacitor. The pulse width of the CU or CD input, which determines the amount of charge transferred to/from the capacitor, is proportional to the magnitude of the detected phase difference. The loop filter converts this charge to a tuning voltage, which controls the output frequency of the VCO. The negative-feedback loop is designed to eliminate the detected phase error. In steady-state operation, the VCO output is phase-locked to the reference signal, and its frequency is an integer or fractional multiple of the reference signal frequency, as determined by the division number input to the divider.

A PLL may operate in the analog or digital domain. Advantages of a digital PLL include the absence of large area capacitors in the analog loop filter, and the possibility to support advanced digital algorithms, such as increasing loop bandwidth during operation to implement fast frequency hops. However, digital PLLs are highly complex, requiring a major design effort. Furthermore, the complexity may be unfeasible for designs requiring operation at very high frequency (e.g., mm-wave) or with ultra-low power consumption.

On the other hand, advantages of an analog PLL include reduced design complexity, and excellent phase noise. As one example of the design trade-offs, the simplicity of an analog PLL makes it an excellent choice at very high frequencies or for very low power. However, the design of an analog PLL is inflexible. For example, the loop filter cannot be re-configured without introducing transients, the bandwidth is limited by the reference frequency used, and the phase detector has a limited range. This combination makes it difficult to increase the speed of frequency acquisition of an analog PLL. The capacitors in the loop filter must be (dis)charged, and the charge pump can only provide a certain charging current. This charging current is set by the PLL bandwidth, which is connected to the filter response, so it typically cannot be increased. Techniques can be used to increase the CP current, such as either reconfiguring the loop filter for higher bandwidth, or reducing the reference frequency and keeping the bandwidth. Regardless, the charging of the loop filter will not be performed with 100% of the available CP current. The linear operation of the PLL will require the charging current to vary during the frequency step. Should the current actually reach 100%, the phase frequency detector (PFD) may tip over, yielding a CU or CD output signal close to zero. This is called a cycle slip and it will slow down the frequency transition by effectively preventing the CU or CD signal from controlling the CP to reach an effective charging current close to 100%. A high CP charging current is desirable, as it minimizes the frequency transition time of the PLL.

US2011/133799A1 discloses a PLL device that is configurable into an analog phase locked loop and a hybrid analog-digital phase locked loop. In an analog mode, at least a phase detector, an analog loop filter, and a voltage controlled oscillator, are connected to form an analog loop. And in a digital mode, at least the phase detector, the voltage controlled oscillator, a time to digital converter, a digital loop filter and a digital to analog converter are connected to form the hybrid digital-analog loop.

The Background section of this document is provided to place embodiments of the present invention in technological and operational context, to assist those of skill in the art in understanding their scope and utility. Approaches described in the Background section could be pursued, but are not necessarily approaches that have been previously conceived or pursued. Unless explicitly identified as such, no statement herein is admitted to be prior art merely by its inclusion in the Background section

**SUMMARY**

The following presents a simplified summary of the disclosure in order to provide a basic understanding to those of skill in the art. This summary is not an extensive overview of the disclosure and is not intended to identify key/critical elements of embodiments of the invention or to delineate the scope of the invention. The sole purpose of this summary is to present some concepts disclosed herein in a simplified form as a prelude to the more detailed description that is presented later. The scope of the invention is defined by the appended set of claims.

A hybrid Phase Locked Loop (PLL) employs an analog control loop during a first period of operation, such as steady-state operation, to achieve a simple design, stable operation at very high frequency, and low phase noise. During a second period of operation, such as frequency changes, a digital control loop takes over. One of the CU/CD inputs to the charge pump (CP) is forced at or near 100% duty cycle for fast, linear frequency change. The CP output to the loop filter may be supplemented by an additional current source. A switch in loop filter (LF) bypasses the resistor, leaving only capacitive (dis)charging. Then a digital control loop controls the division number of the VCO output dividing circuit. The digital control loop measures when the target frequency is reached, and exits the second mode of operation with the proper feedback signal phase. The digital control loop can operate in two control modes. In a first mode, the phase of the divided VCO output signal is synchronized with the phase of a periodic reference signal throughout the frequency change. The integer and the fractional parts of the division number are controlled to achieve a close phase match, based on quantization of the phase-frequency detector (PFD) outputs by a time-to-digital converter (TDC). In a second mode, the frequency and phase are controlled in separate steps. The frequency convergence is detected by monitoring the TDC outputs for a minimum (or zero) difference between two or more consecutive samples. During the phase control step, the LF resistor bypass switch is turned off, preferably by successively turning off multiple small switch elements. This avoids spikes on the VCO tuning voltage, which translate to output frequency glitches. Three embodiments are disclosed. In a first embodiment, a switch before the CP substitutes constant CU/CD signals for the PFD outputs to maximize the loop filter current. In a second embodiment, a pulse suppression (PS) circuit suppresses one pulse of one of the periodic signals, forcing the PFD to output a CU/CD signal at near 100% duty cycle. In a third embodiment, the CP circuit suppresses all pulses of one of the periodic signals, forcing a first PFD to output a constant CU/CD signal. A separate PFD receives the periodic signals and outputs signals indicative of their phase difference, which are quantified by a TDC for use by the digital control loop. The two PFDs are mutually exclusively active.

One embodiment relates to a hybrid Phase Locked Loop (PLL). The hybrid PLL includes a Voltage Controlled Oscillator (VCO) configured to generate a VCO output signal having a frequency determined by a VCO control input signal; a frequency divider circuit configured to divide the frequency of the VCO output signal by a controlled division number; a Phase Frequency Detector (PFD) configured to generate PFD output signals indicative of a difference in edge timing between the divided VCO output signal and a reference periodic signal; a loop filter including a capacitor and configured to generate the VCO control input signal; a charge pump having Charge Up (CU) and Charge Down (CD) inputs and configured to inject a corresponding current into the loop filter; an analog control loop configured to generate the VCO control input signal during a first period of operation; and a digital control loop configured to generate the VCO control input signal during a second period of operation, by digitally controlling the CU and CD inputs to the charge pump.

Another embodiment relates to a method of controlling a hybrid Phase Locked Loop (PLL). The hybrid PLL includes a Voltage Controlled Oscillator (VCO) configured to generate a VCO output signal having a frequency determined by a VCO control input signal; a frequency divider circuit configured to divide the frequency of the VCO output signal by a controlled division number; a Phase Frequency Detector (PFD) configured to generate PFD output signals indicative of a difference in edge timing between the divided VCO output signal and a reference periodic signal; a loop filter including a capacitor and configured to generate the VCO control input signal; a charge pump having Charge Up (CU) and Charge Down (CD) inputs and configured to inject a corresponding current into the loop filter; an analog control loop configured to generate the VCO control input signal during a first period of operation; and a digital control loop configured to generate the VCO control input signal during a second period of operation, by digitally controlling the CU and CD inputs to the charge pump.

Yet another embodiment relates to a Radio Frequency transceiver. The RF transceiver includes receiver circuitry and transmitter circuitry. The RF transceiver further includes one or more hybrid PLLs. Each hybrid PLL includes a Voltage Controlled Oscillator (VCO) configured to generate a VCO output signal having a frequency determined by a VCO control input signal; a frequency divider circuit configured to divide the frequency of the VCO output signal by a controlled division number; a Phase Frequency Detector (PFD) configured to generate PFD output signals indicative of a difference in edge timing between the divided VCO output signal and a reference periodic signal; a loop filter including a capacitor and configured to generate the VCO control input signal; a charge pump having Charge Up (CU) and Charge Down (CD) inputs and configured to inject a corresponding current into the loop filter; an analog control loop configured to generate the VCO control input signal during a first period of operation; and a digital control loop configured to generate the VCO control input signal during a second period of operation, by digitally controlling the CU and CD inputs to the charge pump.

Still another embodiment relates to a base station operative in a wireless communication network. The base station includes processing circuitry and memory operatively connected to the processing circuitry. The base station further includes a transceiver controlled by the processing circuitry. The transceiver includes one or more hybrid PLLs. Each hybrid PLL includes a Voltage Controlled Oscillator (VCO) configured to generate a VCO output signal having a frequency determined by a VCO control input signal; a frequency divider circuit configured to divide the frequency of the VCO output signal by a controlled division number; a Phase Frequency Detector (PFD) configured to generate PFD output signals indicative of a difference in edge timing between the divided VCO output signal and a reference periodic signal; a loop filter including a capacitor and configured to generate the VCO control input signal; a charge pump having Charge Up (CU) and Charge Down (CD) inputs and configured to inject a corresponding current into the loop filter; an analog control loop configured to generate the VCO control input signal during a first period of operation; and a digital control loop configured to generate the VCO control input signal during a second period of operation, by digitally controlling the CU and CD inputs to the charge pump.

Still another embodiment relates to User Equipment (UE) operative in a wireless communication network. The UE includes processing circuitry and memory operatively connected to the processing circuitry. The UE further includes a transceiver controlled by the processing circuitry. The transceiver includes one or more hybrid PLLs. Each hybrid PLL includes a Voltage Controlled Oscillator (VCO) configured to generate a VCO output signal having a frequency determined by a VCO control input signal; a frequency divider circuit configured to divide the frequency of the VCO output signal by a controlled division number; a Phase Frequency Detector (PFD) configured to generate PFD output signals indicative of a difference in edge timing between the divided VCO output signal and a reference periodic signal; a loop filter including a capacitor and configured to generate the VCO control input signal; a charge pump having Charge Up (CU) and Charge Down (CD) inputs and configured to inject a corresponding current into the loop filter; an analog control loop configured to generate the VCO control input signal during a first period of operation; and a digital control loop configured to generate the VCO control input signal during a second period of operation, by digitally controlling the CU and CD inputs to the charge pump.

## BRIEF DESCRIPTION OF THE DRAWINGS

The present invention will now be described more fully hereinafter with reference to the accompanying drawings, in which embodiments of the invention are shown. However, this invention should not be construed as limited to the embodiments set forth herein. Rather, these embodiments are provided so that this disclosure will be thorough and complete, and will fully convey the scope of the invention to those skilled in the art. Like numbers refer to like elements throughout.

Figure 1 is a block diagram of a first embodiment of a hybrid PLL.

Figure 2A is a timing diagram depicting target frequency detection using rising and falling edges.

Figure 2B is a timing diagram depicting target frequency detection using only rising edges.

Figure 3 is a timing diagram showing frequency convergence of the hybrid PLL of Fig. 1.

Figure 4 is a timing diagram showing phase convergence of the hybrid PLL of Fig. 1.

Figure 5 is a simulation result comparing the hybrid PLL of Fig. 1 to the prior art.

Figure 6A is a block diagram of a second embodiment of a hybrid PLL operating in a first control mode.

Figure 6B is a block diagram of the second embodiment of the hybrid PLL operating in a second control mode.

Figure 7 is a timing diagram showing frequency convergence of the hybrid PLL of Fig. 6B.

Figures 8A and 8B are circuit schematics of prior art and inventive PFDs.

Figure 9A is a timing diagram showing TDC operation using the full bit width.

Figure 9B is a timing diagram showing TDC operation using less than full bit width.

Figure 10 is a timing diagram showing phase convergence of the hybrid PLL of Fig. 6B.

Figure 11 is a simulation result comparing the hybrid PLL of Fig. 6A, 6B to the prior art.

Figure 12A is a simulation result comparing frequency ramping of the hybrid PLLs of Figs. 1 and 6A, 6B.

Figure 13 is a block diagram of a third embodiment of a hybrid PLL.

Figure 14 is a timing diagram showing frequency convergence of the hybrid PLL of Fig. 13.

Figure 15 is a timing diagram showing suppression of periodic signals to force charge pump inputs inactive during a phase control step.

Figures 16A and 16B are timing diagrams showing phase convergence of the hybrid PLL of Fig. 13.

Figure 17 is a simulation result comparing the hybrid PLL of Fig. 13 to the prior art.

Figure 18A is a schematic diagram of a prior art loop filter.

Figure 18B is a schematic diagram of a loop filter with inventive resistor bypass switch.

Figure 19 is a simulation result comparing the loop filters of Figs. 18A and 18B.

Figures 20A, 20B, and 20C simulation results depicting various loop filter resistor bypass switching times and modes.

Figure 21 shows simulation results comparing the loop filters of Figs. 18A and 18B.

Figure 22 is a flow diagram of a method of operating a hybrid PLL.

Figure 23 is a block diagram of a base station.

Figure 24 is a block diagram of User Equipment.

## DETAILED DESCRIPTION

For simplicity and illustrative purposes, the present invention is described by referring mainly to an exemplary embodiment thereof. In the following description, numerous specific details are set forth in order to provide a thorough understanding of the present invention. However, it will be readily apparent to one of ordinary skill in the art that the present invention may be practiced without limitation to these specific details. In this description, well known methods and structures have not been described in detail so as not to unnecessarily obscure the present invention.

First Embodiment

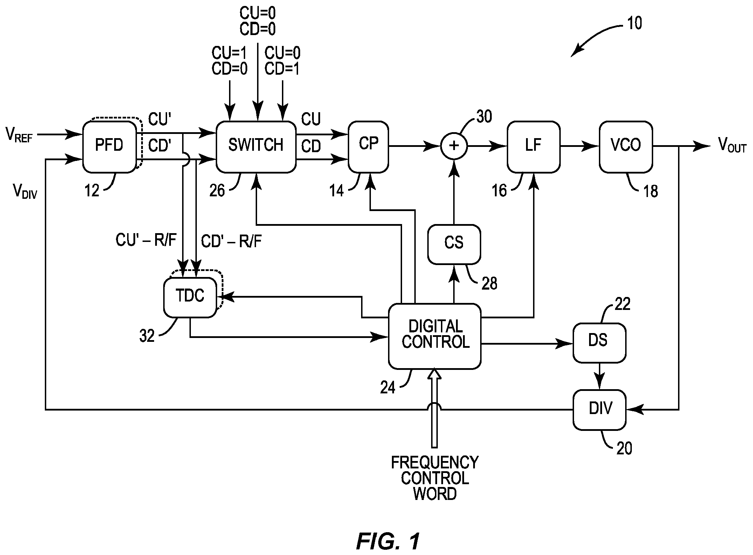

Figure 1 depicts a hybrid PLL 10 according to a first embodiment of the present invention. As used herein, the term "hybrid PLL" refers to a Phase Locked Loop circuit that is a hybrid between analog and digital designs. In particular, the hybrid PLL 10 includes an analog control loop that is configured to control a loop filter 16 to generate a control input signal to a Voltage Controlled Oscillator (VCO) 18 during a first period of operation, such as steady-state operation. Additionally, the hybrid PLL 10 includes a digital control loop configured to control the loop filter (LF) 16 to generate the VCO 18 control input signal during a second period of operation, such as during changes in the output frequency, by controlling the charging of a capacitor in the loop filter in response to timing of outputs of a Phase Frequency Detector (PFD) 12.

The hybrid PLL is first described with reference to its analog control loop. A VCO 18 is configured to generate a periodic output signal having a frequency determined by a VCO control input signal. A frequency divider circuit (DIV) 20 is configured to divide the frequency of the VCO output signal by a controlled division number, and the divided VCO output signal is provided to the PFD circuit 12. The PFD 12 is configured to output CU'/CD' signals indicative of a difference in edge timing between the divided VCO output signal and a reference periodic signal, which may for example be generated by a precision source, such as a crystal oscillator. As used herein, CU'-R/CD'-R denote the outputs of a PFD 12 monitoring rising edges of the periodic signals; CU'-F/CD'-F denote the outputs of a falling edge monitoring PFD 12. In embodiments with only one PFD 12 (triggering on either rising or falling edges), the more general notation CU'/CD' is used. The CU'/CD' signals are inputs to a charge pump (CP) 14 when an intervening switch 26 is in a "pass-through" state (that is, CU=CU' and CD=CD'). As known in the art, the CU and CD charge pump inputs are mutually exclusive, and the duration of a pulse in each signal is proportional to a phase error detected by the PFD 12. In response to the CU or CD signal, the charge pump 14 injects positive or negative current, respectfully, into the loop filter 16. (At this point, the current source (CS) 28 is off, and the summing node 30 does not add to the CP current). The CP current charges or discharges, respectfully, a capacitor in the LF 16. The LF 16 converts the charge on this capacitor to a voltage value, which is the control input signal to the VCO 18, and which controls the output frequency of the VCO 18. The LF 16 includes a resistor, which provides a transmission zero in the LF 16 frequency response. In the embodiment depicted, the input to the divider circuit 20 is generated by a delta-sigma ($\Delta\Sigma$) modulator 22, which in turn is controlled by a digital control circuit 24. During the first period of operation, such as steady-state operation, in which the analog control loop controls the VCO 18 inputs, the digital control circuit 24 simply provides a constant Frequency Control Word to the $\Delta\Sigma$ modulator 22, which responsively outputs a bitstream to the divider 20 implementing an integer, and optionally also a fractional, division number. During the first period of operation, such as during steady-state operation, the analog control loop thus comprises the PFD 12, CP 14, LF 16, VCO 18, and frequency divider circuit 20.

When the digital control circuit 24 detects a significant change in the commanded Frequency Control Word, indicating a desired change in the output frequency of the hybrid PLL 10, a digital control loop takes control for a second period of operation, such as to effect very fast frequency changes. Depending on the direction of frequency change (up or down), the digital control circuit 24 controls the switch 26 to substitute, for the CU' and CD' PFD outputs, one of two sets of mutually exclusive fixed values, whereby one of the signals is tied high, and the other is tied low. In this case, either the CU or CD signal is constantly asserted, and the other is off. This forces the CP 14 to generate the maximum current, in a positive or negative sense, respectively, to the integrating capacitor in the LF 16, for the fastest possible charge or discharge of the capacitor. This, in turn, drives the VCO 18 input at the maximum possible rate, to effect the fastest change in VCO output frequency. In some embodiments, the digital control circuit 24 may also activate an optional current source (CS) 28, which provides yet more current to be summed with the CP 14 output at the summing node 30. The CS 28 may be unidirectional or bidirectional, depending on whether the additional speed in the frequency change is required in only one direction, or in both directions. The digital control circuit 24 also controls a switch in the LF 16, in parallel with the resistor. The control circuit 24 may thus effectively remove the resistor during second period of operation, such as frequency changes, leaving the LF 16 with a purely capacitive response and no transmission zero, which will minimize transients at the ends of the second period of operation. During the digital control loop duration, the tuning voltage presented to the VCO 18 increases or decreases linearly, as the LF 16 capacitor is charged or discharged by a constant current.

Two aspects are important to consider during the second period of operation, such as fast frequency changes under the digital control loop. The first is that the VCO output signal frequency must be monitored so it does not overshoot or undershoot the target frequency at the end of the charging, which would lead to increased settling time. The second is that, at least toward the end of the frequency change, the phase of the divided VCO output signal should match that of the reference periodic signal as closely as possible; otherwise there will also be a prolonged settling time when returning to the first period of operation, such as steady-state operation under the analog control loop. Both of these aspects are addressed, in a first control mode for the first embodiment, by making the divided VCO output signal phase track that of the reference period signal throughout the frequency transition. This is accomplished by monitoring the phase error output by the PFD 12.

To enable the digital control circuit 24 to monitor the PFD 12 outputs, a time to digital conversion (TDC) circuit 32 is enabled. The TDC 32 receives the PFD 12 outputs, and provides the digital control circuit 24 with digital values of the widths of the CU' and CD' pulses. The digital control circuit 24 monitors the TDC 32 outputs, and controls the division number of the frequency dividers to minimize the detected phase error. During the second period of operation, such as during frequency changes, the digital control loop thus comprises the ΔΣ-modulator 22, frequency divider 20, PFD 12, TDC 32, and digital control circuit 24. In this manner, when the division number (integer and fractional parts) has reached the target, a measurement indicates that the CP 14 charging has reached the target and that it can stop. The LF 16 capacitors then hold the desired charge, the LF 16 outputs the desired VCO control input signal, and the divided VCO output signal is in phase with the reference periodic signal. The hybrid PLL 10 may then return to analog control, with a minimum of settling transient to reach the first period of operation, such as steady-state operation at the new frequency.

Alternatively, in a second control mode for the first embodiment, the second period of operation, such as a frequency change, is a two-step operation, wherein the frequency and phase are controlled separately. During a frequency control step, the LF 16 is charged until the voltage of the VCO control input signal reaches a value close to that corresponding to the desired frequency. To determine when that condition is met, and the charging should be stopped, the TDC 32 outputs are monitored. The desired frequency is set by the Frequency Control Word, which sets both the integer and fractional part of the frequency division number. Applying this frequency division, when the target frequency is reached, the signals from the PFD 12 will be constant from sample to sample. The TDC 32 outputs are thus monitored for providing minimum (or zero) difference between two or more consecutive samples, after which the frequency ramping step is stopped.

When applying the frequency division number, the new integer value is set directly in the frequency divider 20. However, since the fractional part is obtained through the ΔΣ-modulator 22, a hop from one value to another cannot be made directly, and the ΔΣ-modulator 22 takes additional time before reaching steady-state and converging to the new desired fractional part. In order to converge the fractional part to the new value faster, the ΔΣ-modulator 22 input can be decreased or increased (based on which value - old or new - is greater) proportionally with the difference between the new value and an average of the ΔΣ-modulator 22 output over multiple cycles. For example, in one embodiment a 63-cycles average is used. This average is obtained as the sum of the values '1' in a 63-bit shift register which samples the ΔΣ-modulator 22 output. It is important that the fractional part converges to the desired value before the end of the frequency control step to obtain good frequency accuracy. This is enabled by configuring both the current in the CS 28 (which changes the frequency ramp rate) and the multiplying factor for the ΔΣ-modulator 22 input change (which changes the ΔΣ-modulator 22 output convergence speed).

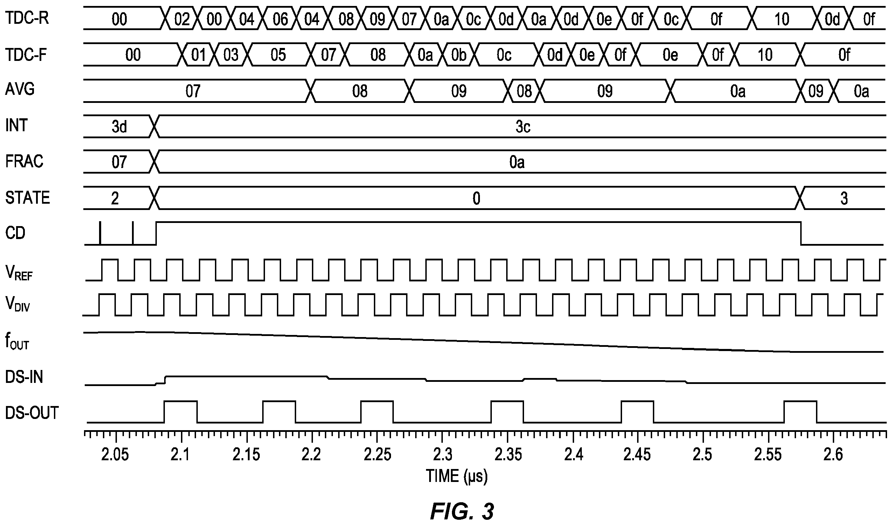

During this step, in one implementation, one TDC 32 is used to monitor the pulse length of the CU'-R or CD'-R signals generated by the PFD 12, which is triggered on the rising edges of the reference periodic signal $V_{REF}$ and divided VCO output signal $V_{DIV}$ (TDC-R signal in Fig. 3). Alternatively, in another implementation, the maximum slope of the change in VCO output frequency can be doubled by using a second TDC 32, which monitors the pulse length of the charge up or charge down signals CU'-F or CD'-F generated by a second PFD 12, which is triggered on the falling edges of the reference periodic signal $V_{REF}$ and divided VCO output signal $V_{DIV}$ (TDC-F signal in Fig. 3). In the first implementation, the values read from the single TDC 32 must be equal over four consecutive rising edges. In the second implementation, the values read on the two TDCs 32 (having the same resolution) must be equal over four consecutive edges (both rising and falling). Note that for all the simulation results presented in this disclosure, a 6-bit resolution was used for the TDC 32. In the following discussion, the second implementation is described, employing two TDCs 32 and two PFDs 12.

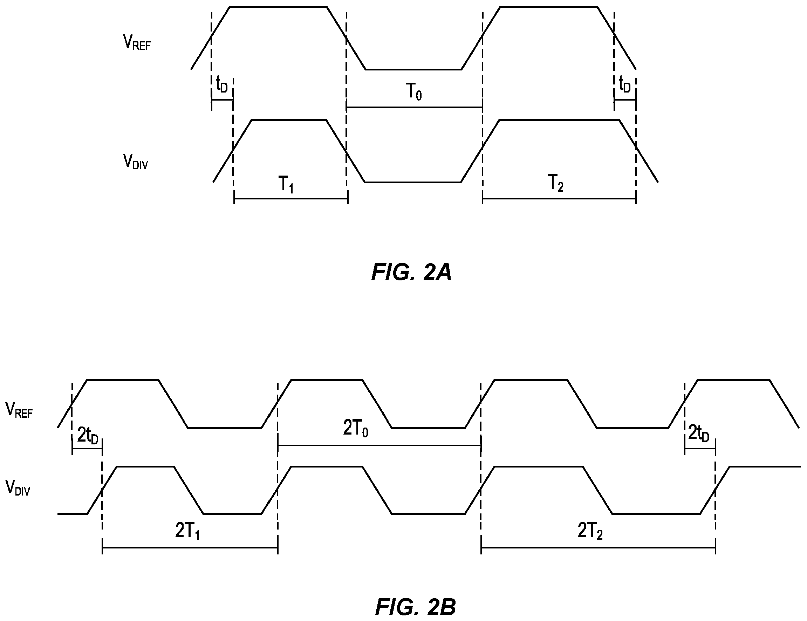

Figure 2A depicts the condition where the frequency ramping should stop. The upper curve is the reference periodic signal $V_{REF}$ (*i.e.,* the frequency target), the frequency of which is constant. The lower curve is the divided VCO output signal $V_{DIV}$, the frequency of which is changing (decreasing, in this example) due to a forced continuous "pulse" of CU/CD, and possibly additional current from a CS 28. In the center of the figure, for half-cycle $T_0$, the frequencies of the two signals are equal, and the ramping step should stop. Because the frequency of the divided VCO output signal $V_{DIV}$ is higher to the left, and lower to the right of $T_0$, the zero crossings to the left and right will deviate (in opposite directions) by $t_D$. Figure 2A depicts the periodic reference signal $V_{REF}$ and divided VCO output signals $V_{DIV}$ - that is, the inputs to the PFDs 12 - to explain the frequency ramping and its termination detection. The TDCs 32 receive the CU'-R/CD'-R and CU'-F/CD'-F signals output by the respective PFDs 12, wherein differences in timing between respective edges of the periodic signals is indicated by the lengths of the pulses, which the TDCs 32 convert to digital values. The digital control circuit 24 then calculates the relative edge timings based on these values. If the signal edge timing deviations $t_D$ depicted in Figure 2A are less than the resolution of the TDCs 32, they will not be detected. Accordingly, the resolution of the TDCs 32 impacts the maximum frequency ramping rate, or slope, that can be employed for a given design. To ascertain this slope, the following equations 1-5 were developed, assuming the ideal case where the edge timing deviations $t_D$ precisely correspond to the TDC 32 resolution (*i.e.,* the value of the LSB). N is the (same) number of bits in each TDC 32, and $f_{ref}$ is the frequency of the reference periodic signal.

$$t_D = \frac{1}{2^N - 1} \cdot T_0 = \frac{1}{2^N - 1} \cdot \frac{1}{2 \cdot f_{ref}} \qquad (1)$$

$$T_1 = T_0 - t_D = \frac{1}{2 \cdot f_{ref}} \cdot \left( 1 - \frac{1}{\left(2^N - 1\right)} \right) \qquad (2)$$

$$T_2 = T_0 + t_D = \frac{1}{2 \cdot f_{ref}} \cdot \left( 1 + \frac{1}{\left(2^N - 1\right)} \right) \qquad (3)$$

$$\Delta f = f_1 - f_2 = \frac{1}{T_1} - \frac{1}{T_2} = 4 \cdot f_{ref} \cdot \frac{2^N - 1}{2^N \cdot \left(2^N - 2\right)} \qquad (4)$$

$$\frac{\Delta f_{out}}{\Delta t} \approx \frac{N_{div} \cdot \Delta f}{3 \cdot T_0} = \frac{4}{3} \cdot N_{div} \cdot \frac{f_{ref}}{T_0} \cdot \frac{2^N - 1}{2^N \cdot \left(2^N - 2\right)} \qquad (5)$$

The slope of the change in VCO output frequency is then estimated as where $N_{div}$ is the integer part in the frequency divider. For example, for $N_{div}$ = 60 and $f_{ref}$ = 40 MHz (yielding an output frequency of $f_{out} = N_{div} * f_{ref}$ = 60*40 MHz = 2.4 GHz), and N = 8 bits, the resulting slope is $\frac{\Delta f_{out}}{\Delta t} \approx 1GHz/u\sec$. This is a very high value, not imposing any practical limitation in this case, as signals yielding a frequency change slope below this value may be reliably detected. Since $N_{div}$ and $f_{ref}$ are often fixed for a given application, the maximum frequency change slope, the termination of which can be accurately detected, is determined by N, the resolution of the TDCs 32. Stated differently, any required slope can be achieved by utilizing TDCs 32 having the required number of bits N. If higher resolution TDCs are used, the stopping condition could instead be that the difference between the consecutive samples is less than a threshold number, rather than being equal to zero.

Figure 2B depicts the case for the first embodiment, where only one PFD 12 - triggered on the rising edges CU'-R/CD'-R of the reference periodic signal $V_{REF}$ and divided VCO output signal $V_{DIV}$ - and one TDC 32 are used. The above analysis holds, with the exception that the time difference between two consecutive monitored edges is $2 * T_0 = 1/f_{ref}$. Hence, the resulting slope for the first embodiment is half of that calculated by equation (5) for the second embodiment. Of course, those of skill in the art may readily utilize a single PFD 12 and TDC 32, with the PFD 12 triggering on the falling edges and outputting CU'-F/CD'-F.

In real-world operating conditions, the ΔΣ-modulator 22 will create additional jitter in the divided VCO output signal, which may result in different values in the TDCs 32, from cycle to cycle. This jitter must be subtracted from $t_D$ in the calculation above. In case the cycle-to-cycle jitter is very small with respect to $t_D$, then the stop condition can be based on the monitoring of only four consecutive edges, as depicted in the example of Figure 2. However, if the cycle-to-cycle jitter is comparable to $t_D$, the TDC 32 resolution may be maintained as a constant and the signals compared, and the slope calculated, over a longer time period (more than four edges, the slope being proportional to the output frequency distance to the target). Alternatively, a lower resolution may be set in the TDC 32.

During the phase control step, the ΔΣ-modulator 22 is used to vary the fractional part for phase alignment (fine tuning), whereas the integer part of the division number is changed with ± 1 unit, to avoid a range under-/overflow when tuning the fractional part close to the range boundaries. More generally, the integer part may be controlled over a range of more than ±1 units, to achieve even faster convergence.

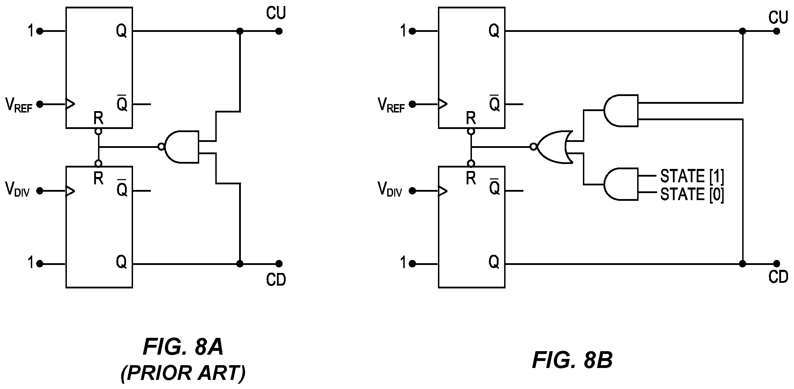

During the phase control step, to control the phase through the digital control loop, the CU/CD signals are switched-off from the charge pump. In the first embodiment, this may be accomplished by controlling the switch 26 to select CU=0 and CD=0. This suppresses the CP 14 from providing any charge/discharge current to the LF 16. Rather, all control of the output signal phase is performed by the digital control circuit 24 controlling the integer and fractional parts of the division number, based on the timing of CU'/CD' signals from the PFD 12, as quantized by the TDCs 32. Alternatively, the charge pump can be disabled by suppressing the CU' and CD' signals in the PFD 12, based on the state of the digital control loop (see Fig. 8B, discussed in greater detail below).

Figure 3 depicts a simulation of the hybrid PLL 10 of Figure 1 during the frequency step of the second period of operation, such as a frequency change, according to the second control mode. Values of the digital buses in Figure 3 are expressed in hexadecimal. Based on a new received Frequency Control Word, a large downwards frequency step is detected. In response, the digital control loop is activated, as indicated by the STATE variable going from state 2, indicating the first period of operation, such as steady-state operation, with analog control loop, to state 0, indicating a downward frequency change (state 1 indicates an upward frequency change). Both the integer part INT and fractional part FRAC of the frequency divider are set. The digital control circuit 24 configures the switch 26 to select the fixed inputs driving the down, or CD signal to 1 (not pictured, but CU=0). This causes the output frequency $f_{out}$ to begin linearly decreasing. During the second period of operation, such as the frequency change, the ΔΣ-modulator 22 input signal DS-IN is changing based on the difference between the new fractional value FRAC and an average AVG of the ΔΣ-modulator 22 output DS-OUT over multiple cycles. This also increases the rate of '1' values of DS-OUT. The two TDCs 32 monitor the phase difference between the divided VCO output signal $V_{DIV}$ and reference periodic signal $V_{REF}$ on the rising (TDC-R) and falling (TDC-F) edges, respectively. Convergence is achieved when the ΔΣ-modulator 22 output average AVG is equal to the fractional part of the divider FRAC, and the rising and falling edges TDC-R, TDC-F are equal over two reference periodic signal periods (four consecutive edges). At this time, STATE goes to 3, which corresponds to the phase control step, during which the charge up/down signals CU, CD are switched-off in the switch 26.

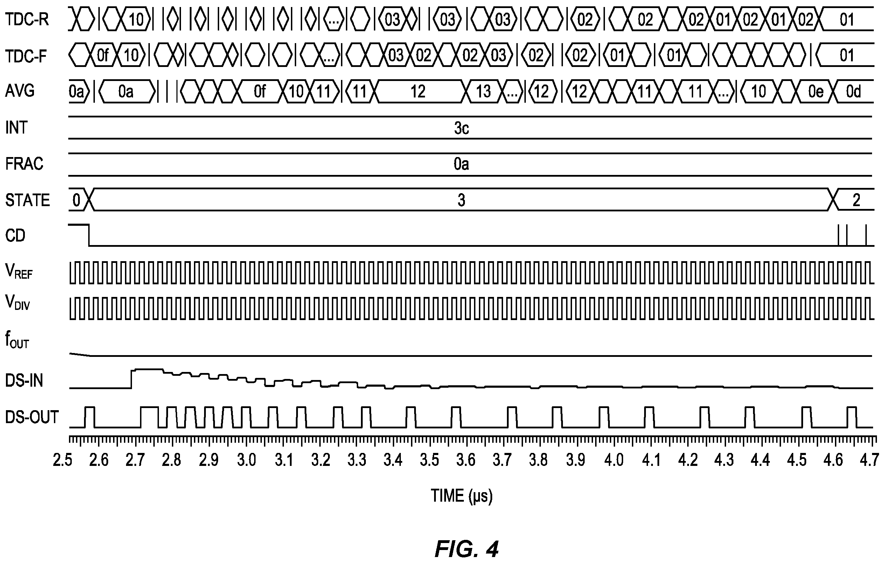

Figure 4 depicts a simulation of the hybrid PLL 10 of Figure 1 during the subsequent phase step of the second period of operation, such as a frequency change, according to the second control mode. During the phase step, the residual phase difference between the divided VCO output signal $V_{DIV}$ and the reference periodic signal $V_{REF}$ is minimized, so that when the first period of operation, such as steady-state operation, is resumed (with analog control loop), there will be a minimum transient to lock the phase. This is done by controlling the input of the ΔΣ-modulator 22 (the difference between the fixed FRAC value and AVG, the running average of DS-OUT), which then controls the fractional division number, and as a result also the phase difference. As described above, the CD signal is forced to 0 during the phase control step, so that the digital control loop controls the phase only by manipulation of the fractional division number. Also, the integer division number INT may be controlled to avoid an overflow, or to speed up the phase step. When the phase has been minimized, TDC-R is close to 0. Note that the ΔΣ-modulator 22 input signal DS-IN requires additional time to converge (Figure 4). After that, the hybrid PLL 10 resumes the first period of operation, such as steady-state operation (with analog control loop), as indicated by the STATE changing to 2.

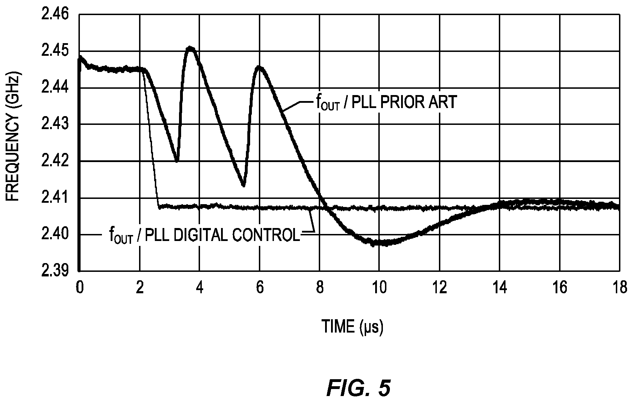

Figure 5 depicts the complete second period of operation, such as a frequency change, for the hybrid PLL 10 of Figure 1, compared to the operation of a prior art PLL. The prior art PLL is prone to cycle slips, which prolong the locking time. As Figure 5 indicates, the digitally controlled frequency change procedures of embodiments of the present invention drastically reduce the locking time, avoiding both cycle slips and slow linear settling.

Referring again to Figure 1, after the target frequency is reached and phase is locked, the TDCs 32 and CS 28 are disabled; the switch 26 is configured to pass CU' and CD' from the PFD 12 directly to the CP 14, and the LF 16 resistor bypass switch is turned off. The signal sent to the ΔΣ modulator 22 and frequency divider 20 is constant - representing the value of the (new) Frequency Control Word - and is no longer controlled by the digital control circuit 24. The hybrid PLL 10 now operates in the first period of operation, such as a steady-state mode, with an analog control loop, as a conventional PLL.

Second Embodiment

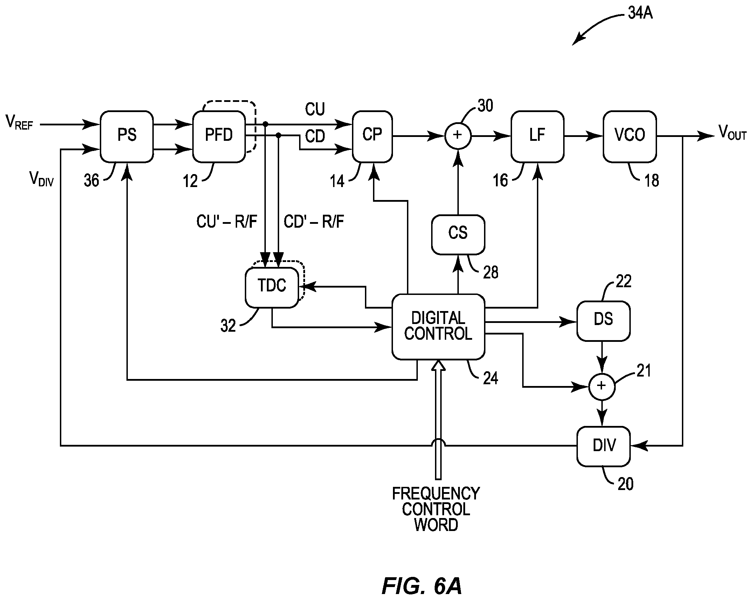

Figure 6A depicts a hybrid PLL 34A according to a second embodiment. The hybrid PLL 34A operates in a first period of operation, such as steady-state, according to an analog control loop, as described above with respect to hybrid PLL 10. The VCO 18 generates a periodic output signal, the frequency of which is determined by a tuning voltage applied to the VCO 18 input. The frequency divider circuit (DIV) 20 divides the frequency of the VCO output signal by a controlled division factor, and the divided VCO output signal $V_{DIV}$ is provided to the PFD circuit 12 (the pulse suppression circuit PS 36, described below, acting in "pass through" mode in the analog control loop). The PFD 12 outputs charge pump control signals CU/CD. In response to these signals, the CP 14 injects the appropriate current into the loop filter 16 (the CS 28 is off in the first period of operation, such as during steady-state mode). The LF 16 converts the charge on a capacitor to a voltage value, which is the input to the VCO 18, and which controls the output frequency of the VCO 18. A switch bypassing an LF 16 resistor is off. The $\Delta\Sigma$ modulator 22 controls the divider 20 based on an applied Frequency Control Word.

The digital control circuit, which controls the hybrid PLL 34A during a second period of operation, such as frequency changes, operates differently to the hybrid PLL 10 embodiment depicted in Figure 1. In this embodiment, there is no switch interposed between the PFD 12 and CP 14. One benefit of this configuration results from the fact that, during the first period of operation, such as steady-state operation, when there are only minor phase differences between the output signal and the reference periodic signal, the CU/CD pulses are very short. A switch, such as switch 26 in Figure 1, in the signal path may degrade the quality of such short pulses. Rather, in this embodiment, to force the pulses on CU/CD to approach 100%, a pulse suppression (PS) circuit 36 is added between the divider 20 and the PFD 12. By suppressing one cycle of the reference periodic signal $V_{REF}$, the PFD 12 CD output will go from very short pulses, as in the first period of operation, such as steady-state operation, to near-100% CD pulses. To avoid precisely hitting the limit, at 100%, the divided VCO output signal $V_{DIV}$ should be retarded by momentarily increasing the division number. To accomplish this, an adder 21 is inserted between the $\Delta\Sigma$-modulator 22 and the frequency divider 20, to add in a value provided by the digital control circuit 24. Similarly, suppressing one cycle of the divided VCO output signal $V_{DIV}$ and momentarily reducing the division number, will force the CU pulses to near-100% duty cycle.

As described with respect to the first embodiment of Figure 1, the additional current source CS 28 can be enabled, and the switch in the LF 16 is preferably enabled to minimize the settling time after the frequency step. The digital control loop will then regulate towards the initial value of the TDC 32, where the pulse length is close to 100%, not towards zero as in the first embodiment. Note that in neither embodiment is any normalization of the TDC 32 response necessary, for instance towards the output period. Apart from controlling towards long CU/CD pulses rather than short, the operation is similar to that of the first embodiment.

When the target frequency has been reached, a pulse is suppressed on the opposite of the two periodic signals feeding the PFD 12, and the opposite decrease/increase of the division number is performed. The PFD 12 then returns to generating short CU/CD pulses; the PS 36, TDC 32, and CS 28 are disabled; the LF 16 switch is opened; and the hybrid PLL 34A returns to the first period of operation, such as steady-state operation, at the new frequency (under analog loop control) with a minimum of settling time.

In a first control mode, as described above, the phase of the divided VCO output signal $V_{DIV}$ is maintained as close as possible to the phase of the reference periodic signal $V_{REF}$ throughout the second period of operation, such as a frequency change operation. In this mode, the signals CU' and CD' sent to the TDC 32 are identical to CU and CD signals sent to the CP 14, so a conventional PFD 12 is used, with a single set of output signals. As also discussed above, if the PFD 12 monitors rising edge timing of the periodic signals $V_{REF}$ and $V_{DIV}$, a second PFD may also be used, to additionally monitor the falling edges (or *vice versa*).

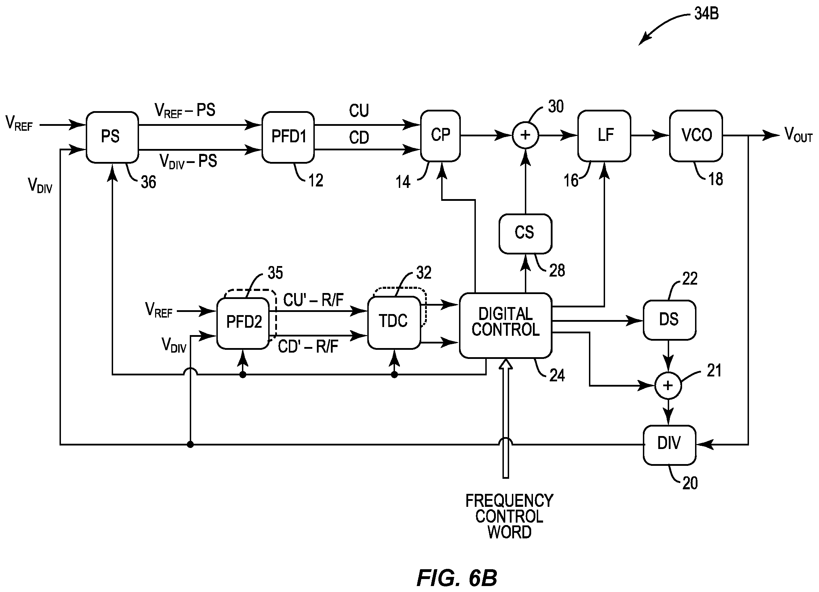

In a second control mode, as also described above, the second period of operation, such as a frequency change, is implemented as a two-step operation, wherein the frequency and phase are controlled separately. Due to differences in the circuits required to implement this second control mode, a slightly different hybrid PLL 34B is depicted in Figure 6B. During a frequency control step, the LF 16 is charged until the voltage of the VCO control input signal reaches a value close to that corresponding to the desired frequency. The desired frequency is given by the Frequency Control Word, which sets both the integer and the fractional part of the division number. The new fractional value is set directly at the start of the frequency control step. In the frequency control step, the only differences with respect to the second control mode of the first embodiment described above is that the CU or CD pulses are close to 100% duration (not completely 100%) and the integer division number is controlled in order to maintain the CU or CD pulses close to 100%, while avoiding an overflow of the PFD1 12, which would result in zero output.

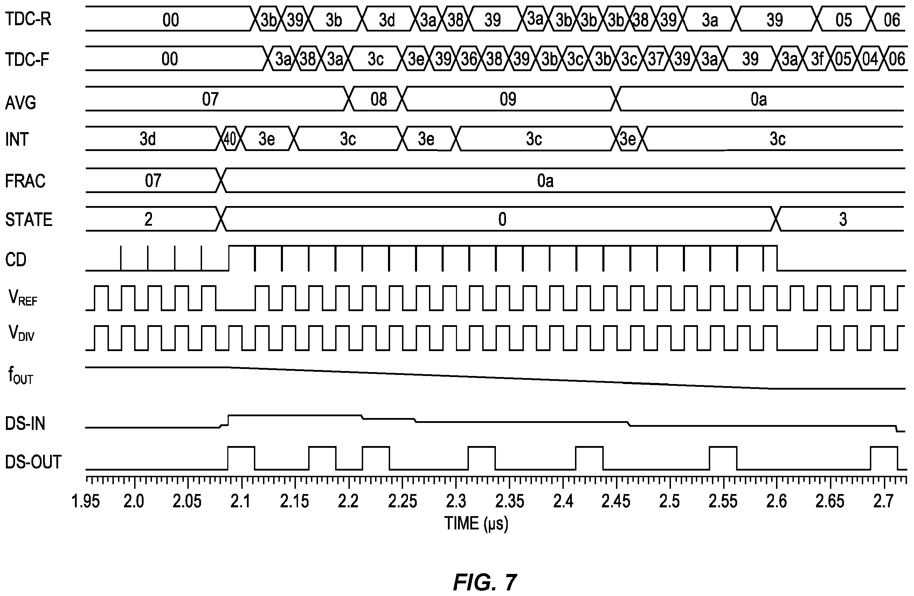

The phase control step proceeds as described above for the phase control step of the first embodiment, with the fractional and/or the integer part of the division number being controlled to achieve phase convergence. In particular, the $\Delta\Sigma$-modulator 22 input is decreased or increased proportionally with the difference between the new output and an average of the $\Delta\Sigma$-modulator 22 output over multiple cycles (such as 63 cycles, *e.g.*, by counting the number of 1 values in a 63-bit shift register). As discussed above, during the phase control step, to control the phase through the digital control loop, the CU/CD signals into the charge pump must be disabled. This may be accomplished by modifying the PFD1 12 to output zero on both outputs when the digital control loop is active, such as by detecting and acting on a particular value of a state machine. Figure 8 depicts one circuit to accomplish this, for the particular case where STATE [1,0] = 11. This circuit was used for the simulations depicted in Figures 7 and 9-12. Alternatively, the PS 36 may monitor the state and suppress both periodic signal outputs, which will cause the PFD1 12 to output zero CU/CD signals.

However, if the CU/CD outputs of the PFD1 12 are suppressed, the digital control loop is unable to monitor the relative timing of the periodic signals $V_{REF}$ and $V_{DIV}$ from it. Accordingly, Figure 6B depicts a hybrid PLL 34B of the second embodiment suited for use where the second control mode (separate frequency and phase adjustments) is employed. In this implementation, the PFD1 12 provides to the CP 14, during the frequency control step, CU/CD pulses that are forced to near 100% duty cycle by the pulse suppression circuit 36, as described. During the phase control step, when the PFD1 12 suppresses CU/CD outputs, a second phase frequency detector PFD2 35 also receives the periodic signals $V_{REF}$ and $V_{DIV}$, and outputs CU'/CD' signals indicative of their relative edge timings to the TDC 32. In the case that both rising and falling edges are monitored, two PFD2s 35 and TDCs 32 are utilized.

The phase control step ends when the phase error for, e.g., four consecutive edges (2 positive and 2 negative) are equal to zero, or below a threshold. The fractional part preferably converges to the desired value before the end of the phase control step to obtain good frequency accuracy. This is enabled by configuring both the current in the CS 28 (which changes the frequency change rate and thereby the time available for convergence of the ΔΣ-modulator 22 in the frequency control step) and the multiplying factor for the ΔΣ-modulator 22 input change (which changes the ΔΣ-modulator 22 output convergence rate).

During the frequency control step, the two TDCs 32 monitor both the rising and the falling edge differences in one of the two directions, based on which signal (CU or CD) is active. Then, for the loop filter charging to stop and the frequency control step to end, the values output by the two TDCs 32 must be equal (or have a variation below a threshold) over, *e.g.*, four consecutive edges. See Figure 2, equations 1-5, and the accompanying discussion, above. In addition, since the integer part of the division number is used to control the duty cycle of the CU/CD pulses (and they are not fixed, as in the second control mode of the first embodiment), it is also required that the integer part of the division number has reached the desired target value before the frequency ramping is stopped.

During the phase control step, the ΔΣ-modulator 22 is used to vary the fractional part for phase alignment (fine tuning), whereas the integer part of the division number is changed with ± 1 unit, to avoid a range under-/overflow when tuning the fractional part close to the range boundaries.

Figure 7 depicts a simulation of the hybrid PLL 34B of Figure 6B during the frequency step of a second period of operation, such as a frequency change, according to the second control mode. Based on a new received Frequency Control Word, a large downwards frequency step is detected. In response, the digital control loop is activated, as indicated by the STATE variable going from state 2, indicating the first period of operation, such as steady-state operation, with analog control loop, to state 0, indicating a downward frequency change (state 1 indicates an upward frequency change). Both the integer part INT and fractional part FRAC of the frequency divider are set. In this case, one cycle of the reference periodic signal $V_{REF}$ is suppressed, which causes the PFD1 12 to generate CD pulses at close to (but not reaching) 100% duty cycle. At the same time, there is a momentary change in the integer part INT of the division number, to avoid an overflow. Two TDCs 32 - one for the rising edge, and one for the falling edge - monitor for frequency convergence, converting the outputs of two PFD2s 35. Each TDC 32 monitors the active one of the CU and CD signals (depending on the direction of the frequency change), in this case the DC signal. As a result, the CD signal is close to 100% duty cycle, and the output frequency $f_{out}$ decreases nearly linearly.

Note that, similar to the first embodiment, during this step the ΔΣ-modulator 22 input DS-IN is changing based on the difference between the new fractional value FRAC and an average of the ΔΣ-modulator 22 output DS-OUT over multiple cycles. This also increases the rate of '1' values at the ΔΣ-modulator 22 output DS-OUT. The two TDCs 32 monitor the phase difference between the divided VCO output signal $V_{DIV}$ and reference periodic signal $V_{REF}$ in the given direction on the rising TDC-R and falling TDC-F edges, respectively. Convergence is achieved when both INT division number and average fractional portion of the division number AVG have reached the target value, and the outputs of the two TDCs 32, TDC-R and TDC-F, are equal over, e.g., two clock reference periods (four consecutive edges). At this time, STATE goes to 3, indicating the phase control step has begun, and a pulse of the divided VCO output signal $V_{DIV}$ is suppressed in order to return to short pulses on CU/CD.

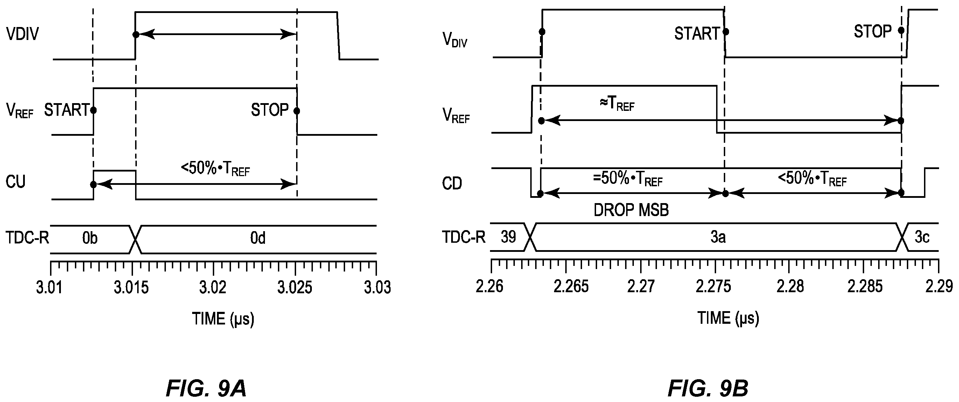

Note that the resolution of the TDC 32 in the second embodiment of the hybrid PLL 34A, 34B (Figures 6A, 6B) is the same as used in the first embodiment (Figure 1). In a straightforward implementation, for close to 100% duty cycle pulses, a 7-bit TDC 32 would be required to cover the full $T_{ref} = 1/f_{ref}$ time period. However, this is achieved with a 6-bit TDC 32 covering only $T_{ref}/2$. Figure 9A depicts operation of the TDC 32 during the second period of operation, such as fast frequency changes, for the first embodiment. In this case, 6 bits is sufficient resolution because the duty cycle of the CU' and CD' signals is a maximum of 50%. As depicted in Figure 9B, during the second period of operation, such as fast frequency changes, for the second embodiment, when the pulses are close to 100% duty cycle, the first MSB (corresponding to 50% duty-cycle) is dropped. The TDC 32 then converts only the time period in excess of $T_{ref}/2$. This means that now the maximum remainder time period to be converted is less than $T_{ref}/2$. This operation is equivalent to a start of the conversion on the falling edge of the divided VCO output signal $V_{DIV}$ or reference periodic signal $V_{REF}$.

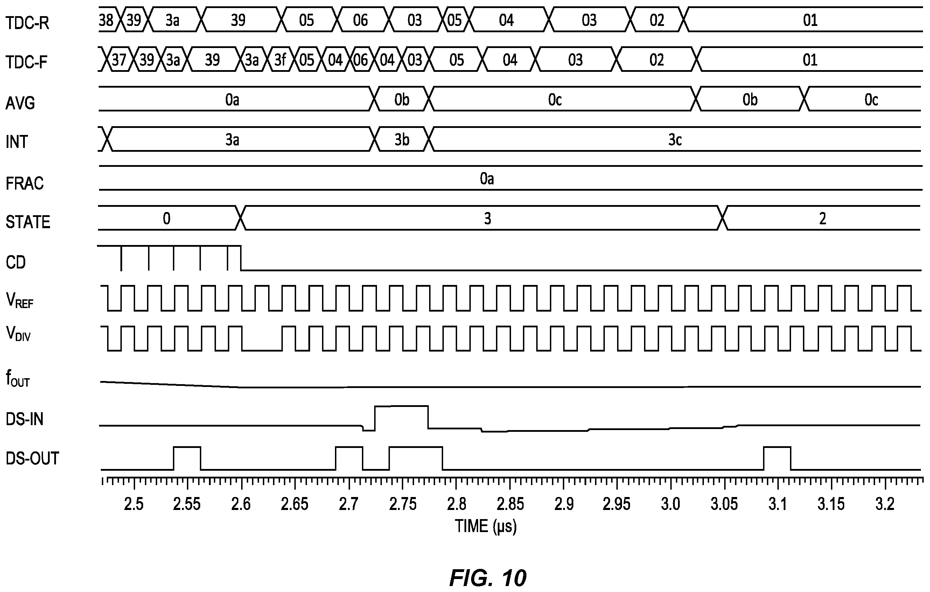

Figure 10 depicts a simulation of the hybrid PLL 34B of Figure 6B during the phase control step of a second period of operation, such as a frequency change, according to the second control mode. At the beginning of the phase control step, one cycle must be suppressed from the opposite signal as that suppressed in the frequency control step, in this case, on the divided VCO output signal $V_{DIV}$. This returns the PFD2 35 outputs to short pulses, to quickly minimize the residual phase. The minimization of residual phase is done by controlling the input of the $\Delta\Sigma$-modulator 22, which then controls the fractional part FRAC of the division number, and as a result also the phase difference between the divided VCO output signal $V_{DIV}$ and the reference periodic signal $V_{REF}$. As compared to the second control mode for the first embodiment (of Figure 1), at the beginning of the phase control step, the phase difference is much smaller, making it easier/faster to converge. This is because maintaining close to 100% duty-cycle CU/CD pulses during the frequency control step corresponds to very small phase difference after suppressing the opposite pulse type. Consequently, the PFD2 35 should provide near-zero pulses, especially if the division ratio is also momentarily increased/decreased in addition to the change performed at the beginning of the frequency control step. Therefore, the phase is recovered faster and the input control voltage for the $\Delta\Sigma$-modulator 22 DS-IN is already close to convergence. Then the hybrid PLL 34B can quickly resume the first period of operation, such as steady-state operation, under an analog control loop (STATE = 2).

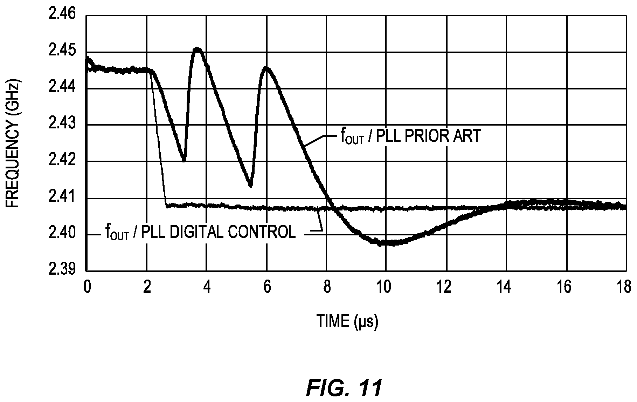

Figure 11 depicts the complete second period of operation, such as a frequency change, for the hybrid PLL 34A of Figure 6A or hybrid PLL 34B of Figure 6B, compared to the operation of a prior art PLL. As noted above, the prior art PLL is prone to cycle slips, which prolong the locking time. As Figure 11 indicates, the digitally controlled frequency change procedures of embodiments of the present invention drastically reduce the locking time, avoiding both cycle slips and slow linear (analog) settling.

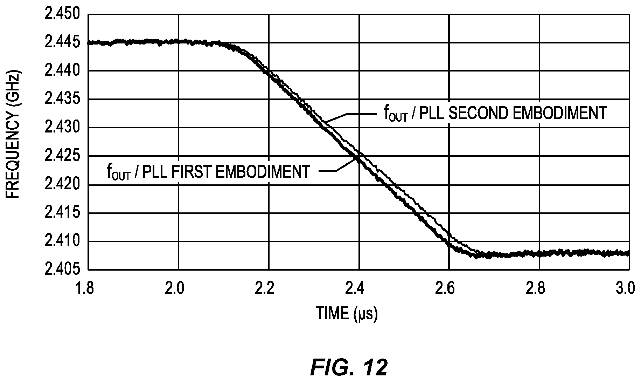

Figure 12 shows a comparison of the second period of operation, such as a fast frequency change, for the first embodiment (hybrid PLL 10, Figure 1) and second embodiment (hybrid PLL 34A, 34B, Figures 6A, 6B), for the same CP 14 current. The frequency change for the second embodiment is only slightly slower in the frequency ramping phase, due to non-100% duty cycle CD pulses.

Third Embodiment

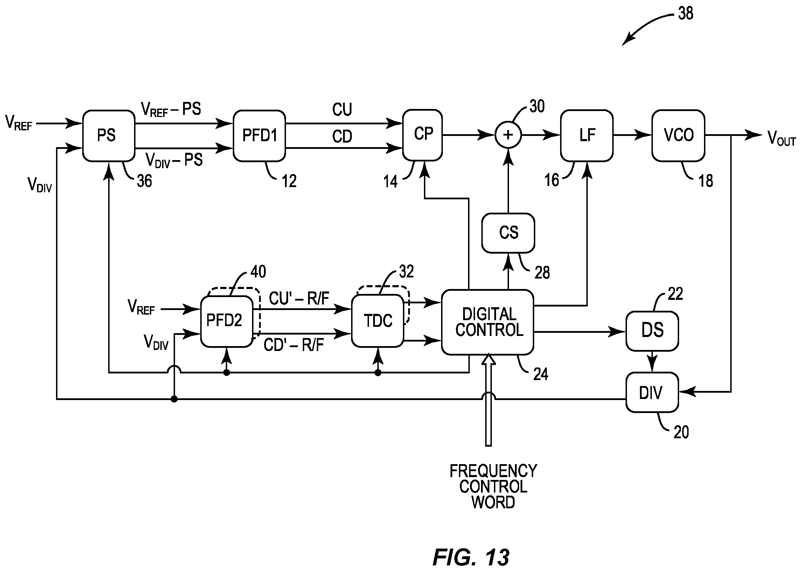

Figure 13 depicts a third embodiment of the present invention, which also utilizes a digital control loop during the second period of operation, such as frequency changes, to achieve very fast frequency hops. This embodiment combines the 100% duty cycle charge pump input feature of the first embodiment, and the pulse suppression technique of the second embodiment, to provide 100% duty cycle on charge pump 14 input signals, while avoiding short pulse switching in the direct path. As described above for the hybrid PLL 34B, an additional PFD2 40 is provided for the digital control loop.

In the hybrid PLL 38, the PS 36 suppresses all cycles of either the divided VCO output signal $V_{DIV}$ or the reference periodic signal $V_{REF}$. This forces the first PFD1 12 to generate a CU or CD signal having 100% duty cycle (*i.e.*, it is continuously on), thus causing the CP 14 to inject the maximum charging or discharging current, respectively, into the LF 16. Note that a second PFD2 40 receives the divided VCO output signal $V_{DIV}$ and reference periodic signal $V_{REF}$ directly - without any cycle suppression. The digital control loop operates on this input.

In the first operating mode, as described above, the phase of the divided VCO output signal is synchronized with the phase of the periodic reference signal throughout the second period of operation, such as a frequency change. The digital control circuit 24 controls the division number (integer and fractional parts) sent to the $\Delta\Sigma$-modulator 22 in response to the pulse lengths of the CU'/CD' signals from the TDC 32, to minimize or eliminate the pulses, corresponding to minimizing or eliminating the phase error between the $V_{DIV}$ and $V_{REF}$ signals. The target frequency has been reached when the frequency division number has reached the target value.

Similarly to the first and second embodiments, the third embodiment also operates in a second operating mode, with separate frequency and phase control steps. During the frequency control step, in a downward (upward) frequency hop, the PS 36 will effectively cancel all $V_{REF}$ ($V_{DIV}$) pulses. As a result, the first PFD1 12 will output a constant CD = 1 (CU = 1) which will cause a linear frequency change, as described above. The CD'/CU' outputs of the second PFD2 40, which receives both $V_{REF}$ and $V_{DIV}$ with no cycle suppression, are quantified by the TDCs 32, and monitored by the digital control circuit 24 to ascertain when the frequency control step should terminate (equal durations between edge transitions over at least two cycles). During a subsequent phase control step, the charge pump inputs are suppressed, and the digital control circuit 24 controls works to minimize the phase error between the $V_{DIV}$ signal and the $V_{REF}$ signal by controlling the fractional (and integer) portion of the division number, in response to the CD'/CU' outputs of the second PFD2 40, as quantified by the TDCs 32.

Although the use of two PFDs 12, 40 slightly increases silicon area, they do not impact power consumption, as they operate at different times. The first PFD1 12 only dynamically switches during the first period of operation, such as steady-state operation of the hybrid PLL 38 (under analog control loop); during this time the second PFD2 40 is disabled. Conversely, the second PFD2 40 only operates during the second period of operation, such as fast frequency changes (under digital control loop); during this time, the PS 36 suppresses all pulses of one of the two periodic signals, so the first PFD1 12 does not switch, but rather outputs either CD=0 and CU=1, or CD=1 and CU=0 (or, in the phase control step of the second control mode, both CU=0 and CD=0).

The additional CS 28 is optionally activated only during the frequency change. The LF 14 switch must be activated at the beginning of the frequency change, and deactivated before resuming the first period of operation, such as steady-state operation. In one embodiment, the LF 14 switch is divided in several unitary cells, which are switched off successively toward the end of the phase control step, when the phase difference is small, in order to minimize spikes in the VCO control voltage. Such spikes would otherwise translate to output frequency glitches.

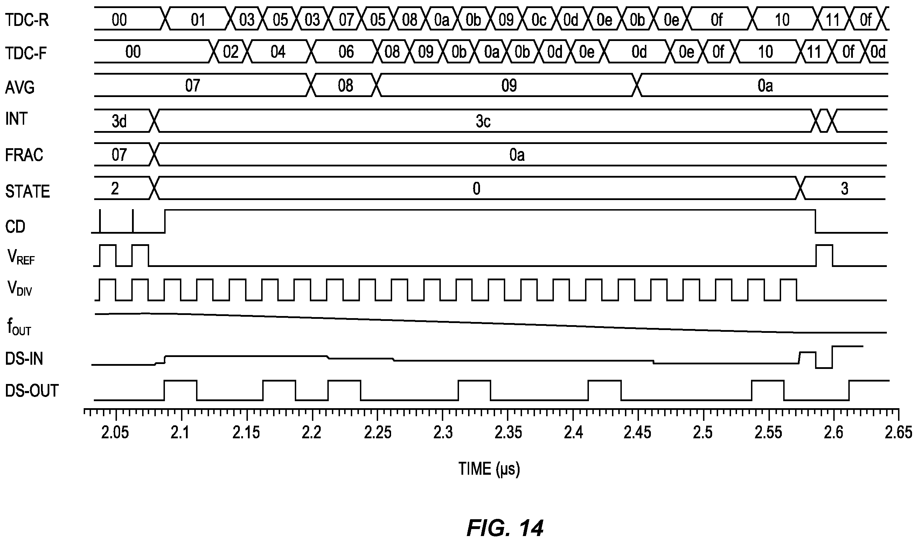

Figure 14 depicts a simulation of the hybrid PLL 38 of Figure 13 during the frequency step of a second period of operation, such as a frequency change, according to the second control mode. The process is similar to that described above with respect to the first embodiment. Convergence is achieved when the average fractional portion of the division number AVG has reached the target value FRAC, and the rising and falling edges are equal over four consecutive edges of the reference periodic signal $V_{REF}$. See Figure 2, equations 1-5, and the accompanying discussion, above. At this time STATE = 3 which corresponds to the phase control step, and the CU/CD signals are deactivated. As described above, this can be implemented either in the first PFD1 12 or the PS 36. For the simulation results presented in Figures 14-17, the PS 36 method to switch off the CU/CD signals was used. As stated above, when STATE = 3, this mechanism enables a continuous suppression of all cycles of both the divided VCO output signal $V_{DIV}$ and reference periodic signal $V_{REF}$, in order to generate zero values on the CU and CD signals going to the CP 14, which will no longer provide charge/discharge current to the LF 16.

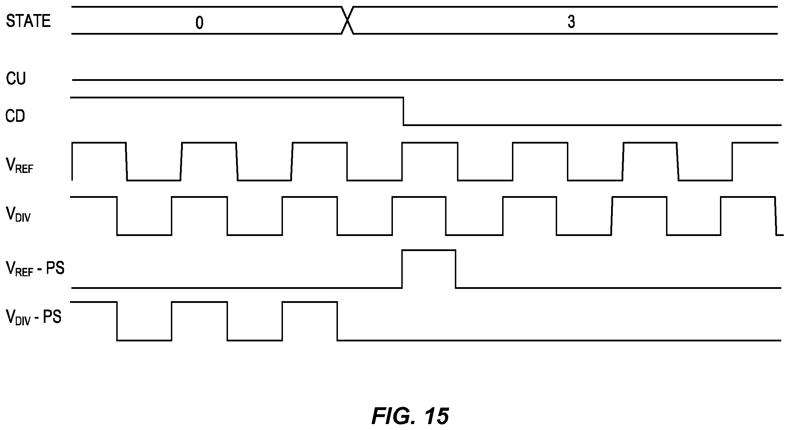

However, in a straightforward implementation, if the PFD1 12 is in state CU=0, CD=1 (or CU=1, CD=0) and the mechanism begins to suppress continuously all cycles of both the divided VCO output signal $V_{DIV}$ and reference periodic signal $V_{REF}$, the PFD1 12 will remain in its previous state, and not reset to CU=0, CD=0. As depicted in Figure 15, in order to enable a correct start-up, immediately after STATE transitions to 3, if the PFD1 12 is in state CU=0, CD=1 (or CU=1, CD=0), then all pulses of $V_{DIV}$ (or $V_{REF}$) are continuously suppressed, but it is necessary to introduce one pulse of $V_{REF}$ (or $V_{DIV}$) before starting to continuously suppress all pulses of $V_{REF}$ (or $V_{DIV}$). Thus, the PFD1 12 will detect a rising edge of $V_{REF}$ (or $V_{DIV}$), which determines a reset of CU and CD outputs. Then, while all pulses of both clock signals are suppressed, the PFD1 12 will not change state, and will output CU=0 and CD=0.

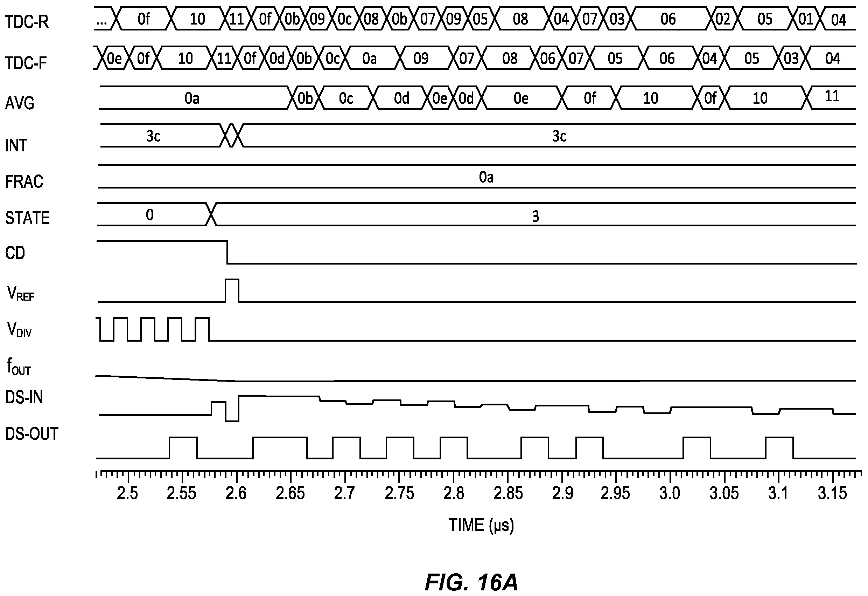

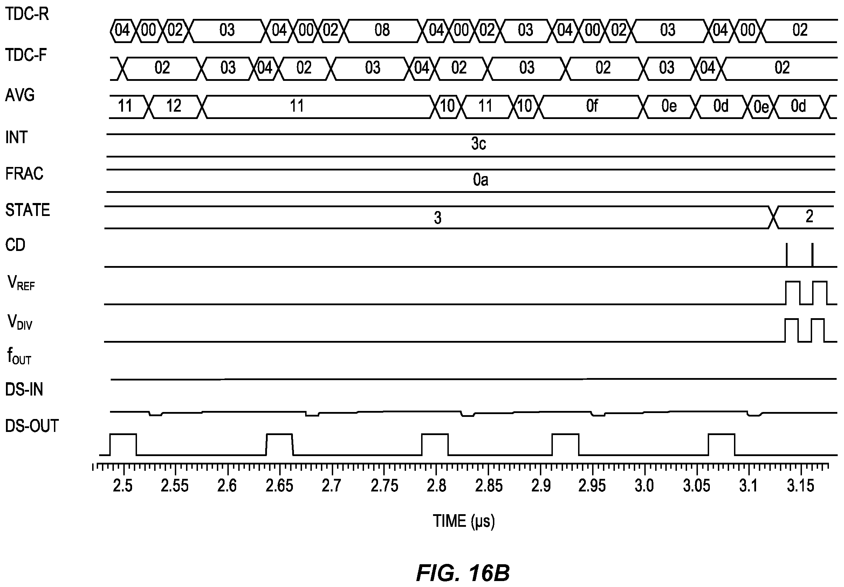

Figures 16A and 16B depict a simulation of the hybrid PLL 38 of Figure 13 during the phase control step of a second period of operation, such as a frequency change, according to the second control mode. As much of the residual phase as possible is canceled by controlling the input DS-IN of the $\Delta\Sigma$-modulator 22, which then controls the fractional portion of the division number with average AVG, and as a result also the phase difference between the divided VCO output signal $V_{DIV}$ and reference periodic signal $V_{REF}$. When the phase is recovered, TDC-R is close to 0 (*i.e.,* TDC=R = 1 at 3.12 $\mu$s). Note that the input control signal DS-IN for the $\Delta\Sigma$-modulator 22 requires time to reach convergence, as indicated in Figure 16A. This is because the $\Delta\Sigma$-modulator 22 tracks the phase difference proportionally - that is, the larger the phase difference, the larger the control signal. Once the phase difference is reduced, then the $\Delta\Sigma$-modulator 22 input control signal DS-IN will also slowly converge, as seen in Figure 15B, and the hybrid PLL 38 resumes the first period of operation, such as steady-state operation (STATE = 2). As noted above, when the phase difference is sufficiently small, the unitary cells comprising the LF 16 switch are turned off successively, to avoid frequency glitches.

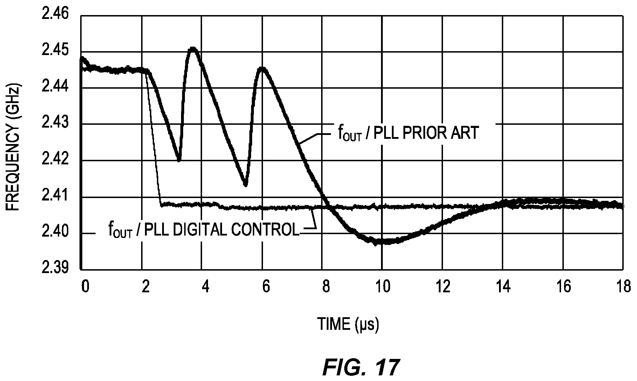

Figure 17 depicts the complete second period of operation, such as a frequency change, for the hybrid PLL 38 of Figure 13, compared to the operation of a prior art PLL. As noted above, the prior art PLL is prone to cycle slips, which prolong the locking time. As Figure 16 indicates, the digitally controlled frequency change procedures of embodiments of the present invention drastically reduce the locking time, avoiding both cycle slips and slow linear (analog) settling.

Upon returning to the first period of operation, such as steady-state operation (STATE = 2), the TDCs 32 are turned off, the PS 36 only acts as clock buffer, and the CS 28 is turned off (the LF 16 switch is already turned off). The signal sent to the $\Delta\Sigma$ modulator 22 and frequency divider 20 is constant, and represents the value of the Frequency Control Word, *i.e.,* it is no longer controlled by the digital control loop.

<u>Loop Filter Resistor Bypass Switching</u>

In all three embodiments of the hybrid PLL 10, 34, 38 described above, the loop filter 16 includes a resistor, which provides a transmission zero in the LF 16 frequency response during the first period of operation, such as steady-state operation. During the second period of operation, such as a frequency change, it is desired to have the loop filter 16 purely capacitive, so that all current injected into the loop filter 16 goes to (dis)charging the loop filter capacitors. Accordingly, a bypass switch is provided to shunt the loop filter resistor to ground by the digital control loop during the second period of operation, such as frequency changes. At the end of the second period of operation, when returning to the first period of operation, such as steady-state operation, the resistor should be restored. Care must be taken in controlling the bypass switch, to avoid output frequency glitches.

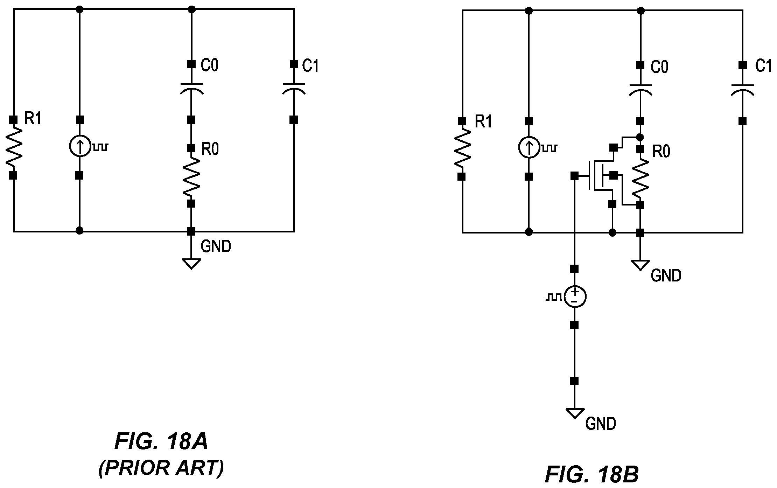

Figure 18A depicts a prior art loop filter LF 16, with a resistor R0 that provides a zero in the transfer function to advance the phase. During the second period of operation, such as a frequency change, when the analog control loop is disabled and a digital control loop controls the hybrid PLL 10, 34, 38 operation, the resistor R0 may be bypassed, as shown in Figure 18B, making the loop filter 16 entirely capacitive. In the circuits of Figures 18A and 18B, the capacitors are 50 pF and 5 pF, and the resistor is 32 kΩ, placing a zero at 100 kHz. The pole is then at 1.1 MHz. This is suitable for use in a PLL with a bandwidth of, *e.g.*, 330 kHz. A charging time of 10 μs with 5 μA was used, using the current sources indicated in the schematic. The switch transistor in Figure 18B is implemented with 40 parallel minimum size transistors in 22 nm FDSOI technology (L=20nm W=80nm, Mult=40). Resistor R1 is very large, and was added for simulation purposes only.

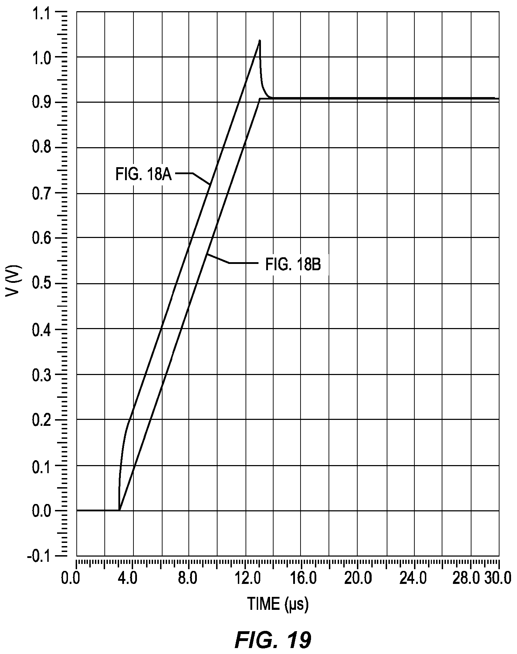

Figure 19 depicts the results of simulation. A large overshoot occurs in the circuit of Figure 18A, with no switch to bypass the resistor. With this loop filter the VCO tuning voltage would reach the target much before the capacitors were fully charged, and the charging would be terminated prematurely. By using the switch in the circuit of Figure 18B, however, the simulated behavior is very close to ideal, with no overshoot to interfere with control of the VCO tuning voltage. The excellent switch performance results from the use of advanced 22nm FDSOI technology, and also very good conditions for a switch transistor, with signals close to ground voltage.

Additionally, the loop filter switch should be turned off during the phase control step, and not at the return to the first period of operation, such as steady-state operation. Turning on/off the LF 16 switch causes small spikes in the VCO tuning voltage, which translate to output frequency glitches. If the LF 16 switch is turned off at the end of the phase control step, it may cause a sudden frequency change, or phase bump, resulting in longer convergence time after the return to the first period of operation, such as steady-state operation. In one embodiment, this is avoided by turning off the LF 16 switch during the phase control step. If the switch is completely turned off during one clock period, there is a sudden frequency glitch as described, but there is still time to recover the output frequency before reaching the end of the phase control step.

In another embodiment, the LF 16 switch is implemented as several identical smaller switches with the same total effective size. Each of these switches is then turned off during successive clock cycles (or other time periods). In this case, the impact of the frequency glitches is even lower, reducing the time needed to recover the correct target frequency.

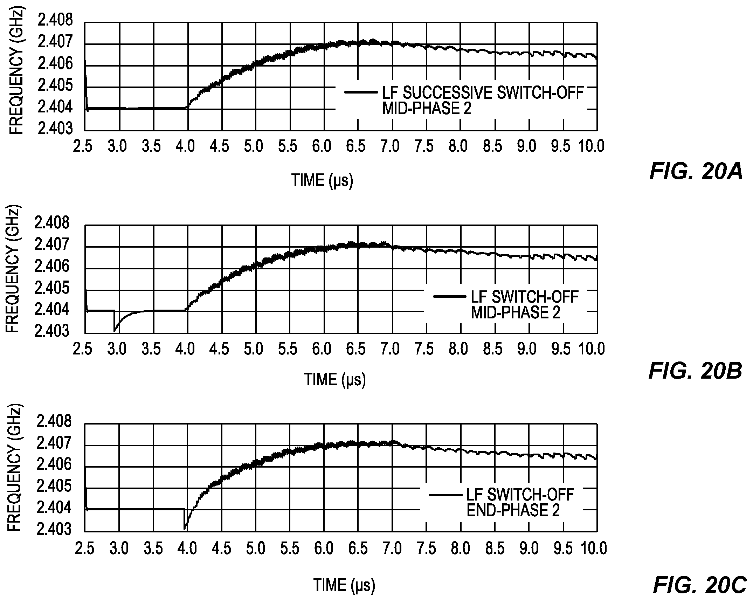

Figures 20A, 20B, and 20C depict the differences in output frequency $f_{out}$ for three different strategies of turning off the LF 16 resistor bypass switch. In Figure 20C, the switch is turned off at the end of the phase control step, resulting in a negative glitch in the output frequency. In Figure 20B, the switch is turned off midway through the phase control step. This also produces a glitch, but the digital control loop has time to recover. Finally, Figure 20A depicts a plurality of switch components being successively turned off over a duration of the phase control step, which eliminates any noticeable glitch in the output frequency.

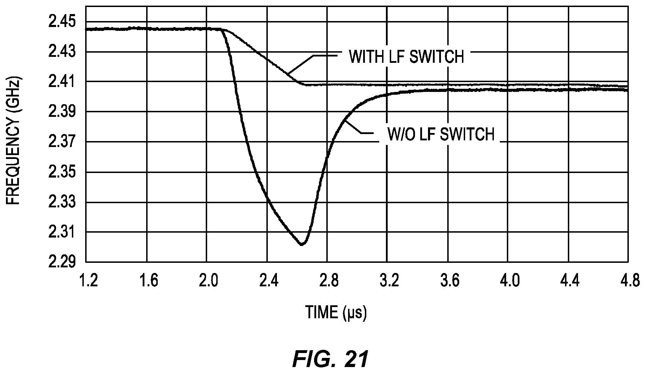

Figure 21 shows the effect of not having a bypass switch at all. When the LF 16 resistor remains in the circuit, a large frequency undershoot results that may cause the frequency control algorithm to fail, as it would stop charging the loop filter too early. In contrast, by removing the resistor with the bypass switch, the frequency change is not only smooth, but completes much sooner.

Method and Wireless Network Apparatus Descriptions

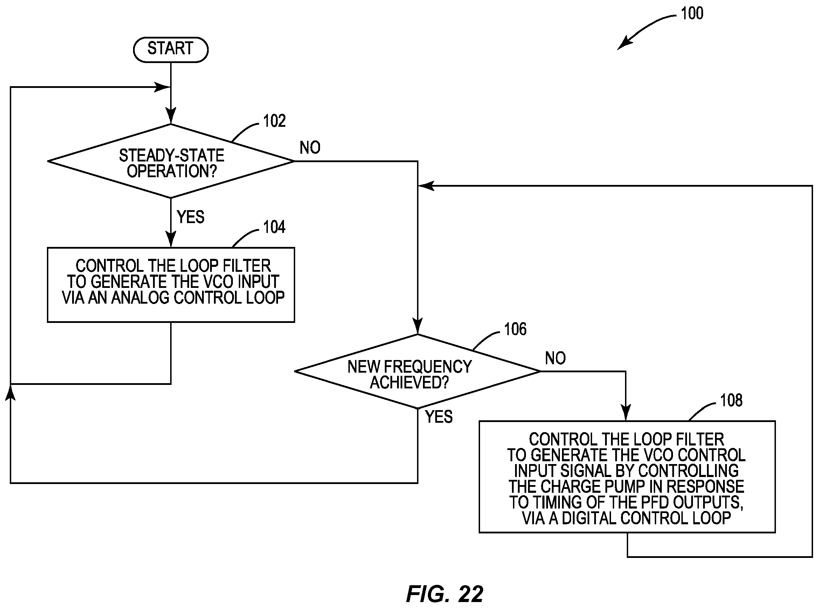

Figure 22 depicts a method 100 of controlling a hybrid PLL 10, 34, 38. As described above, the hybrid PLL 10, 34, 38, comprises at least a VCO 18, a frequency divider circuit 20, a PFD 12, a LF 16 including a capacitor, and a CP 14 configured to charge or discharge the LF capacitor in response to the duty cycle of a CU or CD signal output by the PFD 12. During a first period of operation, such as steady-state operation (block 102), the LF 16 is controlled to generate the VCO control input via an analog control loop (block 104). When a change in commanded frequency is detected, a second period of operation, such as a frequency change, is initiated (block 106). Until the new frequency is achieved (with phase synchronization) (block 106), the LF 16 is controlled to generate the VCO control input signal by controlling the charge pump, in response to timing of the PFD 12 outputs, via a digital control loop (block 108). When the new frequency is achieved (block 106) and the output is phase-synchronized to the reference periodic signal, then the first period of operation, such as steady-state operation, is resumed (blocks 102, 104).

Although the hybrid PLL 10, 34, 38 of embodiments of the present invention may be advantageously used wherever an agile, high-speed, phase-accurate periodic signal generator is required, one application is generating periodic signals, such as a Local Oscillator (LO) signal, for RF communication transceiver circuits, particularly in communication protocols utilizing frequency hopping. In particular, the hybrid PLL 10, 34, 38 is suited for use in nodes in a wireless communication network, such as a base station and/or User Equipment (UE).

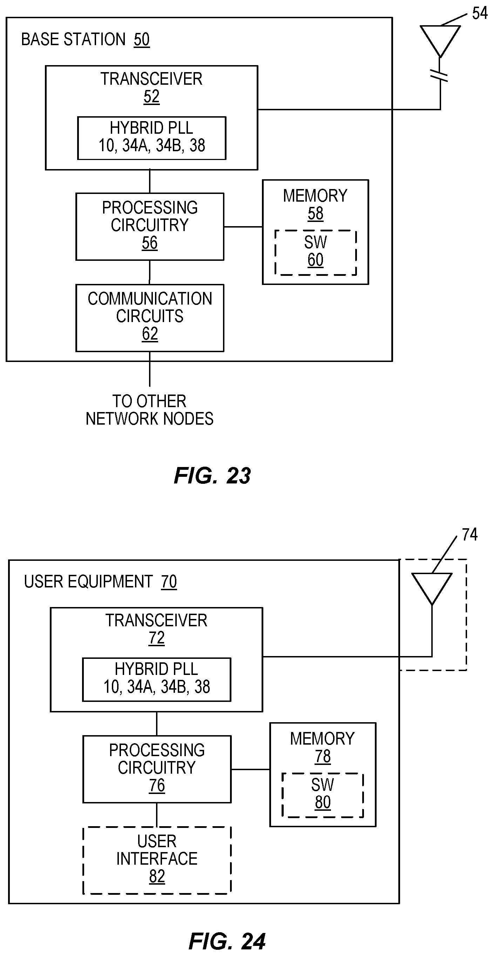

Figure 23 depicts a base station 50 operative in a wireless communication network. As those of skill in the art are aware, a base station 50 is a network node providing wireless communication services to one or more UEs in a geographic region (known as a cell or sector). The base station 50 in LTE is called an e-NodeB or eNB, and in NR is referred to as a gNB; however the present invention is not limited to these protocols. A base station 50 includes radio circuits, such as a transceiver 52, one or more antennas 54, and the like, to effect wireless communication across an air interface to one or more UEs. The transceiver 52 includes one or more hybrid PLLs 10, 34, 38 according to embodiments of the present invention. As those of skill in the art are aware, and as indicated by the continuation lines in the antenna feed line of Figure 23, the antenna(s) 54 may be physically located separately from the base station 50, such as mounted on a tower, building, or the like. The base station 50 further includes processing circuitry 56; memory 58, and communication circuits 62 configured to exchange data with other network nodes. Although the memory 58 is depicted as being separate from the processing circuitry 56, those of skill in the art understand that the processing circuitry 56 includes internal memory, such as a cache memory or register files. Those of skill in the art additionally understand that virtualization techniques allow some functions nominally executed by the processing circuitry 56 to actually be executed by other hardware, perhaps remotely located (*e.g.*, in the so-called "cloud"). According to embodiments of the present invention, the memory 58 is configured to store, and the processing circuitry 56 configured to execute, software 60 which when executed is operative to control one or more hybrid PLLs 10, 34, 38. In particular, the software 60 is configured to execute the method 100 described herein. Alternatively, the method 100 may be executed by digital control circuits 24 within the hybrid PLL 10, 32, 34.

Figure 24 depicts a UE 70 operative in a wireless communication network. As used herein, a UE 70 is any type of device capable of communicating with a base station 50, another UE 70, or other network node, over radio signals. A UE 70 may therefore refer to a machine-to-machine (M2M) device, a machine-type communications (MTC) device, a Narrowband Internet of Things (NB IoT) device, etc. Despite its name, a UE 70 does not necessarily have a "user" in the sense of an individual person owning and/or operating the device. A UE 70 may also be referred to as a radio device, a radio communication device, a wireless communication device, a wireless terminal, or simply a terminal - unless the context indicates otherwise, the use of any of these terms is intended to include device-to-device UEs or devices, machine-type devices, or devices capable of machine-to-machine communication, sensors equipped with a radio network device, wireless-enabled table computers, mobile terminals, smart phones, laptop-embedded equipped (LEE), laptop-mounted equipment (LME), USB dongles, wireless customer-premises equipment (CPE), etc. In the discussion herein, the terms machine-to-machine (M2M) device, machine-type communication (MTC) device, wireless sensor, and sensor may also be used. It should be understood that these devices may be UEs 70, but may be configured to transmit and/or receive data without direct human interaction.

A UE 70 as described herein may be, or may be comprised in, a machine or device that performs monitoring or measurements, and transmits the results of such monitoring measurements to another device or a base station 50. Particular examples of such machines are power meters, industrial machinery, or home or personal appliances, *e.g.* refrigerators, televisions, personal wearables such as watches etc. In other scenarios, a wireless communication device as described herein may be comprised in a vehicle and may perform monitoring and/or reporting of the vehicle's operational status or other functions associated with the vehicle.

The UE 70 includes radio circuits, such a transceiver 72 one or more antennas 74, and the like, to effect wireless communication across an air interface to one or more base stations 50 or other UEs 70. The transceiver 72 includes one or more hybrid PLLs 10, 34, 38 according to embodiments of the present invention. As indicated by the dashed lines, the antenna(s) 74 may protrude externally from the UE 70, or the antenna(s) 74 may be internal. The UE 70 also includes processing circuitry 76; memory 78; and in some embodiments, the UE 70 includes a user interface 82 (*i.e.,* display, touchscreen, keyboard or keypad, microphone, speaker, and the like). In some embodiments, such as in many M2M, MTC, or NB IoT scenarios, the UE 70 may include only a minimal, or no, user interface 82 (as indicated by the dashed lines of block 82 in Figure 24). According to embodiments of the present invention, the memory 76 is configured to store, and the processing circuitry 76 configured to execute, software 80 which when executed is operative to control one or more hybrid PLLs 10, 34, 38. In particular, the software 80 is configured to execute the method 100 described herein. Alternatively, the method 100 may be executed by digital control circuits 24 within the hybrid PLL 10, 34, 38.

In all embodiments described herein, the processing circuitry 56, 76 may comprise any sequential state machine operative to execute machine instructions stored as machine-readable computer programs in the memory, such as one or more hardware-implemented state machines (*e.g.*, in discrete logic, FPGA, ASIC, etc.); programmable logic together with appropriate firmware; one or more stored-program, general-purpose processors, such as a microprocessor or Digital Signal Processor (DSP), together with appropriate software; or any combination of the above.

In all embodiments described herein, the memory 58, 78 may comprise any non-transitory machine-readable media known in the art or that may be developed, including but not limited to magnetic media (*e.g.,* floppy disc, hard disc drive, etc.), optical media (*e.g.,* CD-ROM, DVD-ROM, etc.), solid state media (*e.g.*, SRAM, DRAM, DDRAM, ROM, PROM, EPROM, Flash memory, solid state disc, etc.), or the like.

In all embodiments described herein, the radio circuits may comprise one or more transceivers 52, 72 used to communicate with one or more other transceivers 72, 52 via a Radio Access Network according to one or more communication protocols known in the art or that may be developed, such as IEEE 802.xx, CDMA, WCDMA, GSM, LTE, UTRAN, WiMax, Bluetooth, or the like. The transceiver 52, 72 implements transmitter and receiver functionality appropriate to the Radio Access Network links (*e.g.*, frequency allocations and the like). The transmitter and receiver functions may share circuit components and/or software, or alternatively may be implemented separately.

In all embodiments described herein, the communication circuits 62 may comprise a receiver and transmitter interface used to communicate with one or more other nodes over a communication network according to one or more communication protocols known in the art or that may be developed, such as Ethernet, TCP/IP, SONET, ATM, or the like. The communication circuits 62 implement receiver and transmitter functionality appropriate to the communication network links (*e.g.*, optical, electrical, and the like). The transmitter and receiver functions may share circuit components and/or software, or alternatively may be implemented separately.

Advantages of Embodiments of the Present Invention

Embodiments of the present invention present numerous advantages over PLLs of the prior art. By operating in an analog control loop in a first period of operation, such as steady-state, the hybrid PLL 10, 34, 38 provides a low complexity architecture with tractable design effort, and which can operate at a high frequency with low power consumption and low phase noise. The time required to change frequency, such as for frequency hopping communications protocols, is dramatically reduced by using a digital control loop for a second period of operation, such as frequency changes. The digital circuitry is not utilized most of the time, and hence adds minimal power consumption and has little or no influence on spectral purity in the first period of operation, such as steady-state operation. Both digital control modes disclosed herein result in a phase synchronized signal at the end of the second period of operation, such as frequency change operation, minimizing transient and settling time upon a return to the second period of operation, such as steady-state operation. By using a small NMOS switch with minimum chip area and parasitic effects in the loop filter, the loop filter resistor is bypassed to maximize the frequency change ramp, while minimizing settling transients.

As used herein, the term "configured to" means set up, organized, adapted, or arranged to operate in a particular way; the term is synonymous with "designed to."

The present invention may, of course, be carried out in other ways than those specifically set forth herein without departing from essential characteristics of the invention. The present embodiments are to be considered in all respects as illustrative and not restrictive, and all changes coming within the meaning of the appended claims are intended to be embraced therein.

## Claims

**1.** A hybrid Phase Locked Loop, PLL (10, 34A, 34B, 38), comprising:

a Voltage Controlled Oscillator, VCO (18), configured to generate a VCO output signal having a frequency determined by a VCO control input signal;
a frequency divider circuit (20) configured to divide the frequency of the VCO output signal by a controlled division number;
a Phase Frequency Detector, PFD (12), configured to generate PFD output signals indicative of a difference in edge timing between the divided VCO output signal and a reference periodic signal;
an analog loop filter (16) including a capacitor and configured to generate the VCO control input signal at an output of the analog loop filter (16);
a charge pump (14) having Charge Up, CU, and Charge Down, CD, inputs and configured to inject a corresponding current into the loop filter (16);
an analog control loop configured to generate the VCO control input signal at the output of the analog loop filter (16) during a first period of operation; and

a digital control loop configured to generate the VCO control input signal at the output of the analog loop filter (16) during a second period of operation, by digitally controlling the CU and CD inputs to the charge pump; wherein:

the analog control loop is configured to generate the CU or CD charge pump inputs in response to the PFD output signals; and
the digital control loop is configured to force the CU or CD charge pump inputs to be at or near 100% duty cycle.

**2.** The hybrid PLL (10, 34A, 34B, 38) of claim 1 further comprising a delta-sigma modulator (22) configured to provide, to the frequency divider circuit (20), a time series of integer division numbers in response to integer and fractional components of the controlled division number.

**3.** The hybrid PLL (10) of claim 1 wherein the digital control loop is configured to generate the CU or CD charge pump inputs at 100% duty cycle by switching the CU or CD charge pump inputs to predetermined voltage values.

**4.** The hybrid PLL (34A, 34B) of claim 1 wherein the digital control loop is configured to generate the CU or CD charge pump inputs near 100% duty cycle by a pulse suppression circuit suppressing at least one pulse in one of the divided VCO output signal and the reference periodic signal, thereby forcing the PFD (12) to output the CU or CD charge pump input near 100% duty cycle in response to the pulse suppression circuit outputs.

**5.** The hybrid PLL (38) of claim 4 wherein the digital control loop is configured to generate the CU or CD charge pump inputs at 100% duty cycle by the pulse suppression circuit suppressing all pulses in one of the divided VCO output signal and the reference periodic signal, thereby forcing the PFD (12) to output the CU or CD charge pump input at 100% duty cycle in response to the pulse suppression circuit outputs.

**6.** The hybrid PLL (10, 34A, 34B, 38) of any preceding claim further comprising a current source (28) configured to inject additional current into the loop filter (16) under the control of the digital control loop.

**7.** A method (100) of controlling a hybrid Phase Locked Loop, PLL (10, 34A, 34B, 38), comprising a Voltage Controlled Oscillator, VCO (18), configured to generate a VCO output signal having a frequency determined by a VCO control input signal, a frequency divider circuit (20) configured to divide the frequency of the VCO output signal by a controlled division number, a Phase Frequency Detector, PFD (12), configured to generate PFD output signals indicative of a difference in edge timing between the divided VCO output signal and a reference periodic signal, an analog loop filter (16) including a capacitor and configured to generate the VCO control input signal at an output of the analog loop filter (16), and a charge pump (14) having Charge Up, CU, and Charge Down, CD, inputs and configured to inject a corresponding current into the loop filter (16), the method (100) comprising:

during a first period of operation, controlling (102) the loop filter (16) to generate the VCO control input signal at an output of the analog loop filter (16) via an analog control loop (104); and
during a second period of operation, controlling (106) the loop filter (16) to generate the VCO control input signal at an output of the analog loop filter (16) by controlling the CU and CD inputs to the charge pump, via a digital control loop (108);
wherein:

the analog control loop is configured to generate the CU or CD charge pump inputs in response to the PFD output signals; and
the digital control loop is configured to force the CU or CD charge pump inputs to be at or near 100% duty cycle.

**8.** The method (100) of claim 7 wherein controlling the loop filter (16) to generate the VCO control input signal via the digital control loop (108) comprises switching the CU and CD inputs to the charge pump (14) to predetermined voltage values having 100% duty cycle.

**9.** The method (100) of claim 7 wherein controlling the loop filter (16) to generate the VCO control input signal via the digital control loop (108) comprises suppressing at least one pulse in one of the divided VCO output signal and the reference periodic signal, forcing the PFD (12) to output the CU or CD charge pump input near 100% duty cycle.

**10.** The method (100) of claim 7 wherein controlling the loop filter (16) to generate the VCO control input signal via the digital control loop (108) comprises suppressing all pulses in one of the divided VCO output signal and the reference periodic signal, forcing the PFD (12) to output the CU or CD charge pump input at 100% duty cycle.

**11.** The method (100) of any of claims 7-10 wherein controlling the loop filter (16) to generate the VCO control input signal via the digital control loop (108) further comprises summing the output of the charge pump (14) with additional current prior to injecting the current into the loop filter (16).

**12.** The method (100) of any of claims 7-11 wherein

the hybrid PLL (10, 34A, 34B, 38) further comprises a delta-sigma modulator (22) configured to provide a division number to the frequency divider circuit (20); and
the digital control loop provides integer and fractional parts of the division number to the delta-sigma modulator (22) during the second period of operation.

**13.** A Radio Frequency transceiver (52, 72), comprising:

receiver circuitry;
transmitter circuitry; and

one or more hybrid PLLs (10, 34A, 34B, 38) of any of claims 1 to 6.

**14.** A base station (50) adapted for use in a wireless communication network, the base station comprising the Radio Frequency transceiver (52) of claim 13.

**15.** User Equipment (70) adapted for use in a wireless communication network, the User Equipment comprising the Radio Frequency transceiver (72) of claim 13.

## Patentansprüche

**1.** Hybride Phasenregelschleife, PLL (10, 34A, 34B, 38), umfassend:

einen spannungsgeregelten Oszillator, VCO (18), der dazu konfiguriert ist, ein VCO-Ausgangssignal zu erzeugen, das eine Frequenz aufweist, die durch ein VCO-Regelungseingangssignal bestimmt wird;
eine Frequenzteilerschaltung (20), die dazu konfiguriert ist, die Frequenz des VCO-Ausgangssignals durch eine geregelte Teilungszahl zu teilen;
einen Phasenfrequenzdetektor, PFD (12), der dazu konfiguriert ist, PFD-Ausgangssignale zu erzeugen, die eine Differenz beim Flankenabstand zwischen dem geteilten VCO-Ausgangssignal und einem periodischen Referenzsignal angeben;
ein analoges Schleifenfilter (16), das einen Kondensator beinhaltet und dazu konfiguriert ist, das VCO-Regelungseingangssignal an einem Ausgang des analogen Schleifenfilters (16) zu erzeugen;
eine Ladungspumpe (14), die Charge-Up-Eingänge, CU-Eingänge, und Charge-Down-Eingänge, CD-Eingänge, aufweist und dazu konfiguriert ist, einen entsprechenden Strom in das Schleifenfilter (16) einzuspeisen;
eine analoge Regelungsschleife, die dazu konfiguriert ist, das VCO-Regelungseingangssignal an dem Ausgang des analogen Schleifenfilters (16) während eines ersten Betriebszeitraums zu erzeugen; und
eine digitale Regelungsschleife, die dazu konfiguriert ist, das VCO-Regelungseingangssignal an dem Ausgang des analogen Schleifenfilters (16) während eines zweiten Betriebszeitraums zu erzeugen, indem sie die CU- und CD-Eingänge zu der Ladungspumpe digital regelt; wobei:

die analoge Regelungsschleife dazu konfiguriert ist, die CU- oder CD-Ladungspumpeneingänge als Reaktion auf die PFD-Ausgangssignale zu erzeugen; und
die digitale Regelungsschleife dazu konfiguriert ist, die CU- oder CD-Ladungspumpeneingänge dazu zu bringen, sich bei oder nahe an einem Tastverhältnis von 100 % zu befinden.

**2.** Hybride PLL (10, 34A, 34B, 38) nach Anspruch 1, ferner umfassend einen Delta-Sigma-Wandler (22), der dazu konfiguriert ist, der Frequenzteilerschaltung (20) eine Zeitreihe ganzzahliger Teilungszahlen als Reaktion auf ganzzahlige und gebrochene Komponenten der geregelten Teilungszahl bereitzustellen.

**3.** Hybride PLL (10) nach Anspruch 1, wobei die digitale Regelungsschleife dazu konfiguriert ist, die CU- oder CD-Ladungspumpeneingänge mit einem Tastverhältnis von 100 % zu erzeugen, indem die CU- oder CD-Ladungspumpeneingänge auf vorbestimmte Spannungswerte geschaltet werden.

**4.** Hybride PLL (34A, 34B) nach Anspruch 1, wobei die digitale Regelungsschleife dazu konfiguriert ist, die CU- oder CD Ladungspumpeneingänge mit einem Tastverhältnis nahe 100 % zu erzeugen, indem eine Impulsunterdrückungsschaltung mindestens einen Impuls in einem aus dem geteilten VCO-Ausgangssignal und dem periodischen Referenzsignal unterdrückt, wodurch der PFD (12) dazu gebracht wird, den CU- oder CD-Ladungspumpeneingang mit einem Tastverhältnis nahe 100 % als Reaktion auf die Impulsunterdrückungsschaltungsausgänge auszugeben.

**5.** Hybride PLL (38) nach Anspruch 4, wobei die digitale Regelungsschleife dazu konfiguriert ist, die CU- oder CD Ladungspumpeneingänge mit einem Tastverhältnis von 100 % zu erzeugen, indem die Impulsunterdrückungsschaltung alle Impulse in einem aus dem geteilten VCO-Ausgangssignal und dem periodischen Referenzsignal unterdrückt, wodurch der PFD (12) dazu gebracht wird, den CU- oder CD-Ladungspumpeneingang mit einem Tastverhältnis von 100 % als Reaktion auf die Impulsunterdrückungsschaltungsausgänge auszugeben.

**6.** Hybride PLL (10, 34A, 34B, 38) nach einem der vorhergehenden Ansprüche, ferner umfassend eine Stromquelle (28), die dazu konfiguriert ist, zusätzlichen Strom in das Schleifenfilter (16) unter der Regelung der digitalen Regelungsschleife einzuspeisen.

**7.** Verfahren (100) zum Regeln einer hybriden Phasenregelschleife, PLL (10, 34A, 34B, 38), umfassend einen spannungsgeregelten Oszillator, VCO (18), der dazu konfiguriert ist, ein VCO-Ausgangssignal zu erzeugen, das eine Frequenz aufweist, die durch ein VCO-Regelungseingangssignal bestimmt wird, eine Frequenzteilerschaltung (20), die dazu konfiguriert ist, die Frequenz des VCO-Ausgangssignals durch eine geregelte Teilungszahl zu teilen, einen Phasenfrequenzdetektor, PFD (12), der dazu konfiguriert ist, PFD-Ausgangssignale zu erzeugen, die eine Differenz beim Flankenabstand zwischen dem geteilten VCO-Ausgangssignal und einem periodischen Referenzsignal angeben, ein analoges Schleifenfilter (16), das einen Kondensator beinhaltet und dazu konfiguriert ist, das VCO-Regelungseingangssignal an einem Ausgang des analogen Schleifenfilters (16) zu erzeugen, und eine Ladungspumpe (14), die Charge-Up-Eingänge, CU-Eingänge, und Charge-Down-Eingänge, CD-Eingänge, aufweist und dazu konfiguriert ist, einen entsprechenden Strom in das Schleifenfilter (16) einzuspeisen, wobei das Verfahren (100) Folgendes umfasst:

während eines ersten Betriebszeitraums, Regeln (102) des Schleifenfilters (16), um das VCO-Regelungseingangssignal an einem Ausgang des analogen Schleifenfilters (16) über eine analoge Regelungsschleife (104) zu erzeugen; und,
während eines zweiten Betriebszeitraums, Regeln (106) des Schleifenfilters (16), um das VCO-Regelungseingangssignal an einem Ausgang des analogen Schleifenfilters (16) durch Regeln der CU- und CD-Eingänge zu der Ladungspumpe über eine digitale Regelungsschleife (108) zu erzeugen;
wobei:

die analoge Regelungsschleife dazu konfiguriert ist, die CU- oder CD-Ladungspumpeneingänge als Reaktion auf die PFD-Ausgangssignale zu erzeugen; und
die digitale Regelungsschleife dazu konfiguriert ist, die CU- oder CD-Ladungspumpeneingänge dazu zu bringen, sich bei oder nahe an einem Tastverhältnis von 100 % zu befinden.

**8.** Verfahren (100) nach Anspruch 7, wobei das Regeln des Schleifenfilters (16), um das VCO-Regelungseingangssignal über die digitale Regelungsschleife (108) zu erzeugen, Schalten der CU- und CD-Eingänge in die Ladungspumpe (14) auf vorbestimmte Spannungswerte, die ein Tastverhältnis von 100% aufweisen, umfasst.

**9.** Verfahren (100) nach Anspruch 7, wobei das Regeln des Schleifenfilters (16), um das VCO-Regelungseingangssignal über die digitale Regelungsschleife (108) zu erzeugen, Unterdrücken von mindestens einem Impuls in einem aus dem geteilten VCO-Ausgangssignal und dem periodischen Referenzsignal umfasst, wodurch der PFD (12) dazu gebracht wird, den CU- oder CD-Ladungspumpeneingang mit einem Tastverhältnis nahe 100 % auszugeben.

**10.** Verfahren (100) nach Anspruch 7, wobei das Regeln des Schleifenfilters (16), um das VCO-Regelungseingangssignal über die digitale Regelungsschleife (108) zu erzeugen, Unterdrücken aller Impulse in einem aus dem geteilten VCO-Ausgangssignal und dem periodischen Referenzsignal umfasst, wodurch der PFD (12) dazu gebracht wird, den CU- oder CD-Ladungspumpeneingang mit einem Tastverhältnis von 100 % auszugeben.

**11.** Verfahren (100) nach einem der Ansprüche 7-10, wobei das Regeln des Schleifenfilters (16), um das VCO-Regelungseingangssignal über die digitale Regelungsschleife (108) zu erzeugen, ferner Summieren des Ausgangs der Ladungspumpe (14) mit zusätzlichem Strom umfasst, bevor der Strom in das Schleifenfilter (16) eingespeist wird.

**12.** Verfahren (100) nach einem der Ansprüche 7-11, wobei

die hybride PLL (10, 34A, 34B, 38) ferner einen Delta-Sigma-Wandler (22) umfasst, der dazu konfiguriert ist, der Frequenzteilerschaltung (20) eine Teilungszahl bereitzustellen; und
die digitale Regelungsschleife ganzzahlige und gebrochene Anteile der Teilungszahl an den Delta-Sigma-Wandler (22) während des zweiten Betriebszeitraums bereitstellt.

**13.** Hochfrequenz-Sendeempfänger (52, 72), umfassend:

eine Empfängerschaltung;
eine Senderschaltung; und
eine oder mehrere hybride PLLs (10, 34A, 34B, 38) nach einem der Ansprüche 1 bis 6.

**14.** Basisstation (50), die zur Verwendung in einem drahtlosen Kommunikationsnetz angepasst ist, wobei die Basisstation den Hochfrequenz-Sendeempfänger (52) nach Anspruch 13 umfasst.

15. Benutzereinrichtung (70), die zur Verwendung in einem drahtlosen Kommunikationsnetz angepasst ist, wobei die Benutzereinrichtung den Hochfrequenz-Sendeempfänger (72) nach Anspruch 13 umfasst.

## Revendications

1. Boucle à verrouillage de phase, PLL, hybride (10, 34A, 34B, 38), comprenant :

   un oscillateur commandé en tension, VCO (18), configuré pour générer un signal de sortie de VCO ayant une fréquence déterminée par un signal d'entrée de commande de VCO ;
   un circuit diviseur de fréquence (20) configuré pour diviser la fréquence du signal de sortie de VCO par un nombre de division commandé ;
   un détecteur de phase et de fréquence, PFD (12), configuré pour générer des signaux de sortie de PFD indicatifs d'une différence de temporisation de flanc entre le signal de sortie de VCO divisé et un signal périodique de référence ;
   un filtre de boucle analogique (16) incluant un condensateur et configuré pour générer le signal d'entrée de commande de VCO au niveau d'une sortie du filtre de boucle analogique (16) ;
   une pompe de charge (14) ayant des entrées de charge haute, CU, et de charge basse, CD, et configurée pour injecter un courant correspondant dans le filtre de boucle (16) ;
   une boucle de commande analogique configurée pour générer le signal d'entrée de commande de VCO au niveau de la sortie du filtre de boucle analogique (16) pendant une première période de fonctionnement ; et
   une boucle de commande numérique configurée pour générer le signal d'entrée de commande de VCO au niveau de la sortie du filtre de boucle analogique (16) pendant une seconde période de fonctionnement, en commandant numériquement les entrées CU et CD vers la pompe de charge ; dans laquelle :

   la boucle de commande analogique est configurée pour générer les entrées de pompe de charge CU ou CD en réponse aux signaux de sortie de PFD ; et
   la boucle de commande numérique est configurée pour forcer les entrées de pompe de charge CU ou CD à être à ou proches de 100 % de cycle de service.

2. Boucle PLL hybride (10, 34A, 34B, 38) selon la revendication 1, comprenant en outre un modulateur delta-sigma (22) configuré pour fournir, au circuit diviseur de fréquence (20), une série temporelle de nombres de division entiers en réponse à des composantes entière et fractionnaire du nombre de division commandé.

3. Boucle PLL hybride (10) selon la revendication 1, dans laquelle la boucle de commande numérique est configurée pour générer les entrées de pompe de charge CU ou CD à 100 % de cycle de service en commutant les entrées de pompe de charge CU ou CD vers des valeurs de tension prédéterminées.

4. Boucle PLL hybride (34A, 34B) selon la revendication 1, dans laquelle la boucle de commande numérique est configurée pour générer les entrées de pompe de charge CU ou CD proches de 100 % de cycle de service par un circuit de suppression d'impulsion supprimant au moins une impulsion dans l'un parmi le signal de sortie de VCO divisé et le signal périodique de référence, forçant ainsi le PFD (12) à sortir l'entrée de pompe de charge CU ou CD proche de 100 % de cycle de service en réponse aux sorties du circuit de suppression d'impulsion.

5. Boucle PLL hybride (38) selon la revendication 4, dans laquelle la boucle de commande numérique est configurée pour générer les entrées de pompe de charge CU ou CD à 100 % de cycle de service par le circuit de suppression d'impulsion supprimant toutes les impulsions dans l'un parmi le signal de sortie de VCO divisé et le signal périodique de référence, forçant ainsi le PFD (12) à sortir l'entrée de pompe de charge CU ou CD à 100 % de cycle de service en réponse aux sorties du circuit de suppression d'impulsion.

6. Boucle PLL hybride (10, 34A, 34B, 38) selon l'une quelconque des revendications précédentes, comprenant en outre une source de courant (28) configurée pour injecter un courant supplémentaire dans le filtre de boucle (16) sous la commande de la boucle de commande numérique.

7. Procédé (100) de commande d'une boucle à verrouillage de phase, PLL, hybride (10, 34A, 34B, 38), comprenant un oscillateur commandé en tension, VCO (18), configuré pour générer un signal de sortie de VCO ayant une fréquence déterminée par un signal d'entrée de commande de VCO, un circuit diviseur de fréquence (20) configuré pour diviser la fréquence du signal de sortie de VCO par un nombre de division commandé, un détecteur de phase et de fréquence, PFD (12), configuré pour générer des signaux de sortie de PFD indicatifs d'une différence de temporisation de flanc entre le signal de sortie de VCO divisé et un signal périodique de référence, un filtre de boucle analogique (16) incluant un condensateur et configuré pour générer le signal d'entrée de commande de VCO au niveau d'une sortie du filtre de boucle analogique (16), et une pompe de charge (14) ayant des entrées de charge haute, CU, et de charge basse, CD, et configurée pour injecter un courant correspondant dans le filtre de boucle (16), le procédé (100) comprenant les étapes consistant à :

pendant une première période de fonctionnement, commander (102) le filtre de boucle (16) pour générer le signal d'entrée de commande de VCO au niveau d'une sortie du filtre de boucle analogique (16) via une boucle de commande analogique (104) ; et
pendant une seconde période de fonctionnement, commander (106) le filtre de boucle (16) pour générer le signal d'entrée de commande de VCO au niveau d'une sortie du filtre de boucle analogique (16) en commandant les entrées CU et CD vers la pompe de charge, via une boucle de commande numérique (108) ;
dans lequel :

la boucle de commande analogique est configurée pour générer les entrées de pompe de charge CU ou CD en réponse aux signaux de sortie de PFD ; et
la boucle de commande numérique est configurée pour forcer les entrées de pompe de charge CU ou CD à être à ou proches de 100 % de cycle de service.

**8.** Procédé (100) selon la revendication 7, dans lequel la commande du filtre de boucle (16) pour générer le signal d'entrée de commande de VCO via la boucle de commande numérique (108) comprend la commutation des entrées CU et CD vers la pompe de charge (14) vers des valeurs de tension prédéterminées ayant un cycle de service de 100 %.

**9.** Procédé (100) selon la revendication 7, dans lequel la commande du filtre de boucle (16) pour générer le signal d'entrée de commande de VCO via la boucle de commande numérique (108) comprend la suppression d'au moins une impulsion dans l'un parmi le signal de sortie de VCO divisé et le signal périodique de référence, forçant le PFD (12) à sortir l'entrée de pompe de charge CU ou CD proche de 100 % de cycle de service.

**10.** Procédé (100) selon la revendication 7, dans lequel la commande du filtre de boucle (16) pour générer le signal d'entrée de commande de VCO via la boucle de commande numérique (108) comprend la suppression de toutes les impulsions dans l'un parmi le signal de sortie de VCO divisé et le signal périodique de référence, forçant le PFD (12) à sortir l'entrée de pompe de charge CU ou CD à 100 % de cycle de service.

**11.** Procédé (100) selon l'une quelconque des revendications 7 à 10, dans lequel la commande du filtre de boucle (16) pour générer le signal d'entrée de commande de VCO via la boucle de commande numérique (108) comprend en outre la sommation de la sortie de la pompe de charge (14) avec un courant supplémentaire avant d'injecter le courant dans le filtre de boucle (16).

**12.** Procédé (100) selon l'une quelconque des revendications 7 à 11, dans lequel

la boucle PLL hybride (10, 34A, 34B, 38) comprend en outre un modulateur delta-sigma (22) configuré pour fournir un nombre de division au circuit diviseur de fréquence (20) ; et
la boucle de commande numérique fournit des parties entière et fractionnaire du nombre de division au modulateur delta-sigma (22) pendant la seconde période de fonctionnement.

**13.** Émetteur-récepteur radiofréquence (52, 72), comprenant :

un ensemble de circuits récepteurs ;
un ensemble de circuits émetteurs ; et
une ou plusieurs boucles PLL hybrides (10, 34A, 34B, 38) selon l'une quelconque des revendications 1 à 6.

**14.** Station de base (50) adaptée pour une utilisation dans un réseau de communication sans fil, la station de base comprenant l'émetteur-récepteur radiofréquence (52) selon la revendication 13.

**15.** Équipement utilisateur (70) adapté pour une utilisation dans un réseau de communication sans fil, l'équipement utilisateur comprenant l'émetteur-récepteur radiofréquence (72) selon la revendication 13.

10
$V_{REF}$
$V_{DIV}$
PFD
12
CU'
CD'
CU' – R/F
CD' – R/F
TDC
32
CU=1
CD=0
CU=0
CD=0
CU=0
CD=1
SWITCH
26
CU
CD
CP
14
+
30
LF
16
VCO
18
$V_{OUT}$
CS
28
DIGITAL
CONTROL
24
DS
22
DIV
20
FREQUENCY
CONTROL
WORD


*FIG. 1*

$V_{REF}$
$V_{DIV}$
$t_D$
$T_0$
$T_1$
$T_2$
$2t_D$
$2T_0$
$2T_1$
$2T_2$

*FIG. 2A*

*FIG. 2B*

TDC-R
TDC-F
AVG
INT
FRAC
STATE
CD
$V_{REF}$
$V_{DIV}$
$f_{OUT}$
DS-IN
DS-OUT
2.05
2.1
2.15
2.2
2.25
2.3
2.35
2.4
2.45
2.5
2.55
2.6
TIME (µs)

*FIG. 3*

TDC-R
TDC-F
AVG
INT
FRAC
STATE
CD
$V_{REF}$
$V_{DIV}$
$f_{OUT}$
DS-IN
DS-OUT
3c
0a
3
0
2
2.5 2.6 2.7 2.8 2.9 3.0 3.1 3.2 3.3 3.4 3.5 3.6 3.7 3.8 3.9 4.0 4.1 4.2 4.3 4.4 4.5 4.6 4.7
TIME (µs)

*FIG. 4*

FREQUENCY (GHz)
2.46
2.45
2.44
2.43
2.42
2.41
2.40
2.39
0
2
4
6
8
10
12
14
16
18
TIME (μs)
$f_{OUT}$ / PLL PRIOR ART
$f_{OUT}$ / PLL DIGITAL CONTROL

*FIG. 5*

34A
V_OUT
VCO
18
LF
16
30
+
CP
14
CU
CD
CD' – R/F
CU' – R/F
TDC
32
PFD
12
PS
36
V_REF
V_DIV
CS
28
DIGITAL CONTROL
24
DS
22
21
+
DIV
20
FREQUENCY CONTROL WORD

*FIG. 6A*

34B
VCO
18
$V_{OUT}$
LF
16
30
+
CP
14
PFD1
12
PS
36
CU
CD
$V_{REF}$ – PS
$V_{DIV}$ – PS
$V_{REF}$
$V_{DIV}$
CS
28
DIGITAL CONTROL
24
DS
22
+
21
DIV
20
TDC
32
PFD2
35
CU' – R/F
CD' – R/F
$V_{REF}$
$V_{DIV}$
FREQUENCY CONTROL WORD

*FIG. 6B*

TDC-R
TDC-F
AVG
INT
FRAC
STATE
CD
$V_{REF}$
$V_{DIV}$
$f_{OUT}$
DS-IN
DS-OUT
1.95
2.0
2.05
2.1
2.15
2.2
2.25
2.3
2.35
2.4
2.45
2.5
2.55
2.6
2.65
2.7
TIME (μs)

*FIG. 7*

CU
CD
STATE [1]
STATE [0]
Q
Q̄
R
R
Q̄
Q
1
$V_{REF}$
$V_{DIV}$
1
CU
CD
Q
Q̄
R
R
Q̄
Q
1
$V_{REF}$
$V_{DIV}$
1

FIG. 8B

FIG. 8A
(PRIOR ART)

VDIV
VREF
START
STOP
CU
<50%•TREF
TDC-R
0b
0d
3.01
3.015
3.02
3.025
3.03
TIME (µs)
VDIV
VREF
CD
TDC-R
START
STOP
≈TREF
=50%•TREF
<50%•TREF
DROP MSB
39
3a
3c
2.26
2.265
2.27
2.275
2.28
2.285
2.29
TIME (µs)

FIG. 9A

FIG. 9B

TDC-R
TDC-F
AVG
INT
FRAC
STATE
CD
$V_{REF}$
$V_{DIV}$
$f_{OUT}$
DS-IN
DS-OUT
2.5
2.55
2.6
2.65
2.7
2.75
2.8
2.85
2.9
2.95
3.0
3.05
3.1
3.15
3.2
TIME (µs)

*FIG. 10*

FREQUENCY (GHz)
2.46
2.45
2.44
2.43
2.42
2.41
2.40
2.39
0
2
4
6
8
10
12
14
16
18
TIME (μs)
$f_{OUT}$ / PLL PRIOR ART
$f_{OUT}$ / PLL DIGITAL CONTROL

*FIG. 11*

FREQUENCY (GHz)
2.450
2.445
2.440
2.435
2.430
2.425
2.420
2.415
2.410
2.405
1.8
2.0
2.2
2.4
2.6
2.8
3.0
TIME (μs)
$f_{OUT}$ / PLL SECOND EMBODIMENT
$f_{OUT}$ / PLL FIRST EMBODIMENT

*FIG. 12*

38
VOUT
VCO
18
LF
16
30
+
CS
28
DIGITAL CONTROL
24
DS
22
DIV
20
CP
14
CU
CD
PFD1
12
PS
36
VREF – PS
VDIV – PS
VREF
VDIV
TDC
32
PFD2
40
CU' – R/F
CD' – R/F
FREQUENCY CONTROL WORD

FIG. 13

TDC-R
TDC-F
AVG
INT
FRAC
STATE
CD
$V_{REF}$
$V_{DIV}$
$f_{OUT}$
DS-IN
DS-OUT
2.05
2.1
2.15
2.2
2.25
2.3
2.35
2.4
2.45
2.5
2.55
2.6
2.65
TIME (µs)

*FIG. 14*

STATE
0
3
CU
CD
$V_{REF}$
$V_{DIV}$
$V_{REF}$ - PS
$V_{DIV}$ - PS

*FIG. 15*

TDC-R
TDC-F
AVG
INT
FRAC
STATE
CD
$V_{REF}$
$V_{DIV}$
$f_{OUT}$
DS-IN
DS-OUT
... 0f 10 11 0f 0b 09 0c 08 0b 07 09 05 08 04 07 03 06 02 05 01 04
0e 0f 10 11 0f 0d 0b 0c 0a 09 07 08 06 07 05 06 04 05 03 04
0a 0b 0c 0d 0e 0d 0e 0f 10 0f 10 11
3c
3c
0a
0
3
2.5
2.55
2.6
2.65
2.7
2.75
2.8
2.85
2.9
2.95
3.0
3.05
3.1
3.15
TIME (µs)

*FIG. 16A*

TDC-R
TDC-F
AVG
INT
FRAC
STATE
CD
V_REF
V_DIV
f_OUT
DS-IN
DS-OUT
3c
0a
3
2
2.5
2.55
2.6
2.65
2.7
2.75
2.8
2.85
2.9
2.95
3.0
3.05
3.1
3.15
TIME (μs)

*FIG. 16B*

FREQUENCY (GHz)
2.46
2.45
2.44
2.43
2.42
2.41
2.40
2.39
0
2
4
6
8
10
12
14
16
18
TIME (μs)
$f_{OUT}$ / PLL PRIOR ART
$f_{OUT}$ / PLL DIGITAL CONTROL

*FIG. 17*

C1
C0
R0
GND
GND
R1

FIG. 18B

C1
C0
R0
GND
R1

FIG. 18A
(PRIOR ART)

V (V)
1.1
1.0
0.9
0.8
0.7
0.6
0.5
0.4
0.3
0.2
0.1
0.0
-0.1
0.0
4.0
8.0
12.0
16.0
20.0
24.0
28.0
30.0
TIME (μs)
FIG. 18A
FIG. 18B

FIG. 19

FREQUENCY (GHz)
2.408
2.407
2.406
2.405
2.404
2.403
2.5 3.0 3.5 4.0 4.5 5.0 5.5 6.0 6.5 7.0 7.5 8.0 8.5 9.0 9.5 10.0
TIME (µs)
LF SUCCESSIVE SWITCH-OFF MID-PHASE 2
LF SWITCH-OFF MID-PHASE 2
LF SWITCH-OFF END-PHASE 2

FIG. 20A

FIG. 20B

FIG. 20C

FREQUENCY (GHz)
2.45
2.43
2.41
2.39
2.37
2.35
2.33
2.31
2.29
TIME (µs)
1.2
1.6
2.0
2.4
2.8
3.2
3.6
4.0
4.4
4.8
WITH LF SWITCH
W/O LF SWITCH

*FIG. 21*

100
START
STEADY-STATE OPERATION?
102
YES
NO
CONTROL THE LOOP FILTER TO GENERATE THE VCO INPUT VIA AN ANALOG CONTROL LOOP
104
NEW FREQUENCY ACHIEVED?
106
NO
YES
CONTROL THE LOOP FILTER TO GENERATE THE VCO CONTROL INPUT SIGNAL BY CONTROLLING THE CHARGE PUMP IN RESPONSE TO TIMING OF THE PFD OUTPUTS, VIA A DIGITAL CONTROL LOOP
108

*FIG. 22*

54
BASE STATION 50
TRANSCEIVER
52
HYBRID PLL
10, 34A, 34B, 38
PROCESSING
CIRCUITRY
56
MEMORY
58
SW
60
COMMUNICATION
CIRCUITS
62
TO OTHER
NETWORK NODES


*FIG. 23*

74
USER EQUIPMENT 70
TRANSCEIVER
72
HYBRID PLL
10, 34A, 34B, 38
PROCESSING
CIRCUITRY
76
MEMORY
78
SW
80
USER
INTERFACE
82


*FIG. 24*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2011133799 A1


### Non-patent literature cited in the description


- *3GPP TR 38.802 V0.3.0*, October 2016